(19) Europäisches Patentamt
European Patent Office
Office européen des brevets

(11) Veröffentlichungsnummer: **0 033 721**
**B1**

(12) **EUROPÄISCHE PATENTSCHRIFT**

(45) Veröffentlichungstag der Patentschrift: **14.08.85**

(21) Anmeldenummer: **81810026.5**

(22) Anmeldetag: **30.01.81**

(51) Int. Cl.⁴: **C 08 F 222/40**, C 08 F 8/30, C 08 F 8/34, C 08 J 3/24, C 08 F 2/06 // H05K3/00, G03C1/70 ,(C08F222/40, 228:06)

# (54) Lichtvernetzbare Polymere mit seitenständigen Thioxanthon- und Imidylgruppierungen und Verfahren zu deren Herstellung.

(30) Priorität: **05.02.80 CH 918/80**

(43) Veröffentlichungstag der Anmeldung: **12.08.81 Patentblatt 81/32**

(45) Bekanntmachung des Hinweises auf die Patenterteilung: **14.08.85 Patentblatt 85/33**

(84) Benannte Vertragsstaaten: **CH DE FR GB LI NL**

(56) Entgegenhaltungen:
**EP - A - 0 003 552**
**CH - A - 601 384**
**DE - A - 2 916 383**
**FR - A - 2 272 122**

(73) Patentinhaber: **CIBA-GEIGY AG, Postfach, CH-4002 Basel (CH)**

(72) Erfinder: **Zweifel, Hans, Dr., Lothringerstrasse 93, CH-4056 Basel (CH)**
Erfinder: **Berger, Joseph, Dr., Rte des Préalpes 4, CH-1723 Marly (CH)**
Erfinder: **Kvita, Vratislav, Dr., Vogesenstrasse 71, CH-4153 Reinach (CH)**
Erfinder: **Roth, Martin, Dr., Chemin des Epinettes 12, CH-1723 Marly (CH)**

**EP 0 033 721 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

ACTORUM AG

**Beschreibung**

Die vorliegende Erfindung betrifft neue lichtvernetzbare Polymere mit seitenständigen Thioxanthon- und Imidylgruppierungen und Verfahren zu deren Herstellung.

Es ist bekannt, dass sich gegebenenfalls halogenierte, besonders chlorierte, Thioxanthone als Sensibilisatoren für photoinduzierte Vernetzungsreaktionen eignen. Voraussetzung für eine erfolgreiche derartige Verwendung ist eine gute Verträglichkeit des Sensibilisators im Polymeren, d.h. der Sensibilisator muss bis zu erhöhten Konzentrationen mit dem Polymeren mischbar sein. Ferner müssen die Sensibilisatoren in den bei der Verarbeitung der Polymeren zur Anwendung gelangenden Lösungsmitteln gut löslich sein. Die erwähnten bekannten Thioxanthone genügen diesen Anforderungen nicht in jeder Hinsicht; insbesondere entmischen sie sich leicht im Polymeren, wodurch deren Sensibilisatorwirkung beeinträchtigt wird.

Es wurden nun neue unter der Einwirkung von Licht vernetzbare Polymere gefunden, deren Durchschnittsmolekulargewicht mindestens 5000 beträgt und die seitenständige Thioxanthongruppierungen der Formel I

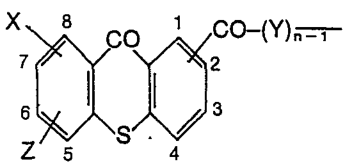

(I)

und seitenständige Imidylgruppierungen der Formel II

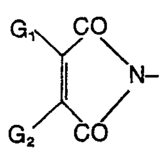

(II)

aufweisen, worin

$G_1$ und $G_2$ unabhängig voneinander Alkyl mit 1–4 C-Atomen der zusammen gegebenenfalls durch Methyl substituiertes Trimethylen oder Tetramethylen,

n die Zahl 1 oder 2,

X Wasserstoff, Halogen, $-CN$, $-NO_2$, Phenylsulfonyl, Alkylsulfonyl, Alkyl, Alkoxy, Alkylthio, N,N-Dialkylamino oder –CO-Alkyl mit je 1–4 C-Atomen in den Alkylteilen,

Z Wasserstoff, Halogen, Alkyl, Alkoxy, Alkylthio oder N,N-Dialkylamino mit je 1–4 C-Atomen in den Alkylteilen,

Y $-OR_1-$, $-SR_1-$ oder $-N(R_2)R_1-$, worin das Heteroatom des Restes Y mit der –CO-Gruppe verbunden ist,

$R_1$ gegebenenfalls verzweigtes Alkylen mit insgesamt 2–23 C-Atomen und 2-13 C-Atomen in der Hauptkette, Cyclopentylen, Cyclohexylen, Phenylen oder

$$-(CH_2CH_2O)_x-CH_2CH_2-,$$

$R_2$ Wasserstoff oder gegebenenfalls verzweigtes Alkyl mit insgesamt 1–23 C-Atomen und 1–13 C-Atomen in der Hauptkette und

x eine ganze Zahl von 1–5 bedeuten,

wobei der Anteil an Gruppierungen der Formel I 0,1 bis 50 Prozent und der Anteil an Gruppierungen der Formel II 5–99,9 Prozent, bezogen auf die Anzahl der wiederkehrenden Strukturelemente des Polymeren, betragen.

Vorzugsweise beträgt der Anteil an Gruppierungen der Formel I 0,1 bis 30 Prozent, und der Anteil an Gruppierungen der Formel II 10 bis 99,9 Prozent, bezogen auf die Anzahl der wiederkehrenden Strukturelemente des Polymeren. Besonders bevorzugt beträgt der Anteil an Gruppierungen der Formel I 0,1 bis 10 Prozent und der Anteil an Gruppierungen der Formel II 30 bis 99,9 Prozent bezogen auf die Anzahl der wiederkehrenden Strukturelemente des Polymeren. Die erfindungsgemässen Polymeren weisen zweckmässig ein Durchschnittsmolekulargewicht von 5000 bis ca. 1 000 000 und insbesondere ein Durchschnittsmolekulargewicht von etwa 10 000 bis 1 000 000 auf. Das Duchschnittsmolekulargewicht wird nach an sich bekannten Methoden, z.B. mittels Streulichtbestimmung oder Gelpermeationschromatographie, bestimmt.

Bei der erfindungsgemässen Polymeren handelt es sich z.B. um Polyäther, Polyamine, Polyimine, Polykondensate auf der Basis von Phenolformaldehyd, Polysaccharide, Gelatine und vor allem um Polymere, welche durch Homo- oder Copolymerisation von C=C Doppelbindungen enthaltenden Monomeren erhalten werden.

Die erfindungsgemässen Polymeren lassen sich nach an sich bekannten Synthesemethoden zur Herstellung von Makromolekülen mit seitenständigen Gruppen herstellen. Grundsätzlich kommen folgende Wege in Betracht:

1. Einbau der Thioxanthonreste der Formel I und der Imidylgruppierungen der Formel II in eine bestehende Polymerkette;

2. Aufbau der Polymerkette aus Monomeren, welche die Thioxanthongruppierung der Formel I bzw. die Imidylgruppierung der Formel II bereits enthalten, wobei die Polymerkette durch Polymerisation aufgebaut werden kann.

Teilweise können mit den Methoden 1 und 2 gleiche Produkte erhalten werden, so dass sich je nach Art der funktionellen Gruppen wahlweise die Methode 1 oder 2 anwenden lässt. Werden die Reste der Formel I und II in eine bereits vorhandene Polymerkette eingebaut, so erfolgt dieser Einbau entweder durch eine Kondensationsreaktion oder durch eine Additionsreaktion unter gleichzeitiger Öffnung eines Ringsystems, z.B. einer Dicarbonsäureanhydridgruppe oder einer Epoxidgruppe.

Nach der vorerwähnten Aufbau-Methode können erfindungsgemässe Polymere dadurch hergestellt werden, dass man entweder

A) eine Verbindung der Formel Ia

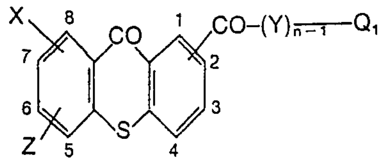

(Ia) ,

worin $Q_1$ bei n = 1 $-OCH=CH_2$, $-OCH_2CH=CH_2$, $-SCH_2CH=CH_2$ oder $-NHCH_2CH=CH_2$ und bei n = 2 $-OCO-C(R'')=CH_2$, $-SCO-C(R'')=CH_2$, $-NHCO-C(R'')=CH_2$, $-OCH=CH_2$

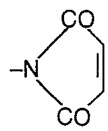

oder, wenn $R_1$ Alkylen oder Phenylen bedeutet, auch $-CH=CH_2$ und R″ Wasserstoff oder Methyl darstellen und für X, Y, Z und n das unter Formel I Angegebene gilt, und eine Verbindung der Formel IIa

Imidyl–$(R_1)_{\overline{n-1}}Q_2$ (IIa),

worin «Imidyl» einen Rest der Formel II darstellt, n und $R_1$ die unter Formel I angegebene Bedeutung haben und $Q_2$ bei n = 1

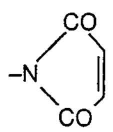 , –NHCO-Alkenyl oder

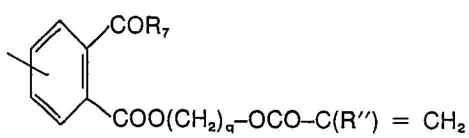

und bei n = 2 –CO–O-Alkenyl, –O-Alkenyl, –OCO-Alkenyl, –NHCO-Alkenyl oder –SCO-Alkenyl bedeutet, wobei die Alkenylteile 2–4 C-Atome aufweisen, $R_7$ –OH oder $-O^-M^+$,

$M^+$ ein Alkalimetall- Pyridinium- oder Trialkylammoniumkation mit insgesamt 3–24 C-Atomen,

q eine ganze Zahl von 2–4 und

R″ Wasserstoff oder Methyl darstellen,

gegebenenfalls in Gegenwart von Comonomeren polymerisiert, wobei das Molverhältnis von Verbindungen der Formel Ia + IIa Comonomeren, 5,1 : 94,9 bis 100 : 0 und das Molverhältnis von Verbindung der Formel Ia zu Verbindung der Formel IIa 0,1 : 99,9 bis 10 : 1 betragen, oder

B) eine Verbindung der Formel Ib

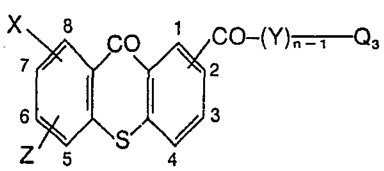

(Ib) ,

worin X, Y, Z und n die unter Formel I angegebene Bedeutung haben, $Q_3$ bei n = 1

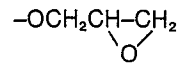

oder $-OCH_2-COOH$ und bei n = 2 –OH, –SH, $OZNH_2$, –NHR′, $-SO_3H$, –COOH, –COCl, –NCO oder

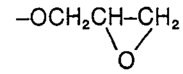

und R′ Alkyl mit 1–5 C-Atomen darstellen, und eine Verbindung der Formel IIb

Imidyl–$(R_1)_{\overline{n-1}}Q_4$ (IIb) ,

worin «Imidyl» einen Rest der Formel II darstellt, $R_1$ und n die unter Formel I angegebene Bedeutung haben, $Q_4$ bei n = 1

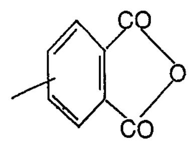

und bei n = 2 –OH, –SH, $-NH_2$, –NHR′, –COOH oder –COCl und R′ Alkyl mit 1–5 C-Atomen bedeuten, mit einem Polymeren mit entsprechenden funktionellen Gruppen in einem Molverhältnis von Verbindungen der Formel Ib + IIb von 5,1 : 100 bis 1 : 1, bezogen auf die Anzahl der wiederkehrenden Strukturelemente des Polymeren, zur Reaktion bringt, wobei das Molverhältnis von Verbindung der Formel Ib zu Verbindung der Formel IIb 0,1 : 99,9 bis 10 : 1 beträgt.

Vorzugsweise betragen das Molverhältnis von Verbindung der Formel Ia + Verbindung der Formel IIa zu Comonomeren in Methode A) 10,1 : 89,9 bis 100 : 0, insbesondere 30,1 : 69,9 bis 100 : 0, und das Molverhältnis von Verbindung der Formel Ia zu Verbindung der Formel IIa 0,1 : 99,9 bis 3 : 1, insbesondere 1 : 1 bis 1 : 3.

Vorzugsweise betragen das Molverhältnis von Verbindungen der Formel Ib und IIb zu Polymeren in Methode B 10,1 : 100 bis 1 : 1, insbesondere 30,1 : 100 bis 1 : 1, bezogen auf die Anzahl der wiederkehrenden Strukturelemente des Polymeren und das Molverhältnis von Verbindung der Formel Ib zu Verbindung der Formel IIb 0,1 : 99,9 bis 3 : 1, insbesondere 1 : 1 bis 1 : 3.

$Q_1$ und $Q_2$ stellen vorzugsweise unabhängig voneinander $-OCH=CH_2$, $-SCO-C(R'')=CH_2$, $-NHCO-C(R'')=CH_2$ und besonders $-OCO-C(R'')=CH_2$ oder $-CH=CH_2$ dar.

Verbindungen der Formel Ib, worin $Q_3$ $-NH_2$ oder –NHR′ bedeutet, können auch in Form von Salzen, besonders Salzen mit anorganischen Säuren, wie HCl, $H_2SO_4$ oder Salpetersäure, vorliegen. $Q_3$ und $Q_4$ stellen bevorzugt unabhängig voneinander –OH, –SH, $-NH_2$, –NHR′, –COOH oder –COCl dar.

Verbindungen der Formel Ib und IIb, worin $Q_3$ und $Q_4$ –COOH, –COCl, $-SO_3H$, $-OCH_2COOH$ oder

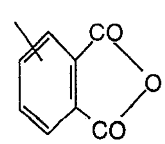

bedeuten, lassen sich beispielsweise mit Polymeren umsetzen, die freie –OH–, $-NH_2-$, –NH-Alkyl- oder –SH-Gruppen aufweisen.

Verbindungen der Formel Ib und IIb, worin $Q_3$ bzw. $Q_4$ –OH, –SH, $-NH_2$, –NHR′, –NCO oder

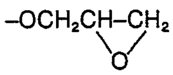

bedeuten, sowie die entsprechenden Salze eignen sich z.B zur Umsetzung mit Polymeren, die Anhydrid- oder –COOH-Gruppen aufweisen. Schliesslich können Verbindungen der Formel Ib und IIb, worin $Q_3$ bzw. $Q_4$ –OH, –SH,$-NH_2$, –NHR′ oder –COOH bedeuten, oder entsprechende Salze auch mit Polymeren umgesetzt werden, die

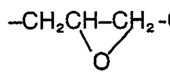-Gruppen

aufweisen.

Es ist auch möglich, die Methoden A) und B) zu kombinieren, indem man zuerst nach der Aufbau-Methode ein Copolymeres mit geeigneten funktionellen Gruppen und 0,1 bis 50 Prozent seitenständigen Thioxanthongruppierungen der Formel I oder 5 bis 99,9 Prozent seitenständigen Imidylgruppen der Formel II (bezogen auf die Anzahl der wiederkehrenden Strukturelemente des Copolymeren) herstellt und anschliessend nach der Einbau-Methode eine Verbindung der Formel IIb in einem Verhältnis von 99,9 : 100 bis 1 : 20 bzw. eine Verbindung der Formel Ib in einem Verhältnis von 0,1 : 100 bis 1 : 2 mit dem Copolymeren zur Reaktion bringt, wobei sich die angegebenen Verhältnisse auf die Anzahl der wiederkehrenden Strukturelemente des Ausgangs-Copolymeren beziehen.

Definitionsgemässe Alkyl-, Alkoxy- und Alkylthiogruppen $G_1$, $G_2$, X, Z, R′ oder $R_2$ bzw. Alkylteile in Resten X oder Z können geradkettig oder verzweigt sein. Alkylengruppen $R_1$ und Alkylgruppen $R_2$ weisen bevorzugt insgesamt höchstens 18 und insbesondere höchstens 12 C-Atome auf.

Als Beispiele definitionsgemässer Alkyl-, Alkoxy-, Alkylthio-, Alkylsulfonyl-, N,N-Dialkylamino- und –CO-Alkylgruppen $G_1$, $G_2$, X Z, R′ oder $R_2$ seien genannt: die Methyl-, Äthyl-, n-Propyl-, Isopropyl-, n-Butyl-, sek-Butyl-, n-Pentyl-, 2- oder 3-Pentyl-, n-Hexyl-, n-Heptyl-, 2- oder 3-Heptyl, n-Octyl-, n-Nonyl-, n-Decyl-, 2-Decyl-, n-Dodecyl-, n-Tridecyl-, Tridec-7-yl-, Heptadec-9-yl, 2,6,10-Trimethyldodecyl- und 2,6,10,14-Tetramethylhexadecylgruppe; die Methoxy-, Äthoxy-, n-Propoxy-, Isopropoxy- und n-Butoxygruppe; die Methylthio-, Äthylthio- und n-Propylthiogruppe; die Methyl- und Äthylsulfonylgruppe; die N,N-Dimethylamino-, N,N-Diäthylamino-, N-Methyl-N-äthylamino- und N,N-Di-n-propylaminogruppe; die Acetyl-, Propionyl- und Butyrylgruppe.

Alkylgruppen $G_1$, $G_2$, R′, X und Z sind bevorzugt geradkettig und weisen insbesondere 1 oder 2 C-Atome auf. $G_1$ und $G_2$ stellen bevorzugt zusammen Trimethylen oder Tetramethylen, insbesondere jedoch je Methyl dar.

Als Beispiele definitionsgemässer Alkylengruppen $R_1$ seien erwähnt: die 1,2-Äthylen-, Propylen-, Tetramethylen-, Isobutylen-, Pentamethylen-, Iso- und Neopentylen-, Hexamethylen-, Heptamethylen-, 2- oder 3-Methylhexalen-, Octamethylen-, Nonamethylen-, Decamethylen-, 2-Methylnonylen-, Dodecamethylen-, Tridecamethylen-, Hexalheptylen-, Octylnonylen-, 2,6,10-Trimethyldecylen-, 2,6,10,14-Tetramethyldodecylengruppe.

Stellt $R_2$ eine Cyclopentylen-, Cyclohexylen- oder Phenylengruppe dar, so handelt es sich z.B. um die 1,3-Cyclopentylen-, 1,3- oder insbesondere 1,4-Cyclohexylen-, 1,3- oder 1,4-Phenylengruppe.

$R_1$ stellt bevorzugt Alkylen mit insgesamt 2–18 und insbesondere 2–12 C-Atomen, 1,3-Cyclopentylen, 1,4-Cyclohexylen oder eine Gruppe $-(CH_2CH_2O)_2-CH_2CH_2-$ dar. $R_2$ ist vorzugsweise Wasserstoff, $M^+$ stellt beispielsweise das Lithium-, Natrium-, Trimethylammonium-, Triäthylammonium-, Methyldiäthylammonium- oder das Tri-n-octylammoniumkation dar. Bevorzugt bedeutet $M^+$ ein Alkalimetallkation, besonders das Natriumkation.

Unter den erfindungsgemässen Polymeren sind solche mit Gruppierungen der Formel I und II bevorzugt, worin $G_1$ und $G_2$ je Methyl und Z Wasserstoff bedeuten, X, Y und n die unter Formel I angegebene Bedeutung haben und die Gruppierung $-CO-(Y)_{\overline{n-1}}$ sich in 1- oder 3-Stellung befindet.

Eine weitere Klasse von bevorzugten Polymeren sind solche mit Gruppierungen der Formel I und II, worin $G_1$ und $G_2$ je Methyl darstellen, X in 6-Stellung gebunden ist und $-NO_2$, Alkylsulfonyl mit 1–4 und vor allem 1 oder 2 C-Atomen oder Phenylsulfonyl bedeutet, Z in 7-Stellung gebunden ist und Alkyl, Alkoxy, Alkylthio oder N,N-Dialkylamino mit je 1–4 C-Atomen und insbesondere 1 oder 2 C-Atomen in den Alkylteilen bedeutet und die Gruppierung $-CO-(Y)_{\overline{n-1}}$ sich in 1- oder 3-Stellung befindet.

Gemäss einer weiteren Bevorzugung sind $G_1$ und $G_2$ je Methyl, Z stellt Wasserstoff dar, X ist in 6-Stellung gebunden und $-NO_2$, Alkylsulfonyl mit 1–4 C-Atomen und insbesondere 1 oder 2 C-Atomen oder Phenylsulfonyl bedeutet und die Gruppierung $-CO-(Y)_{\overline{n-1}}$ in 1- oder 3-Stellung gebunden ist.

Ganz besonders bevorzugt sind Polymere mit Gruppierungen der Formel I und II, worin X Wasserstoff, Z Wasserstoff oder in 7-Stellung gebundenes Methyl oder Methoxy und $G_1$ und $G_2$ je Methyl bedeuten und die Gruppe $-CO-(Y)_{\overline{n-1}}$ sich in 1- oder 3-Stellung befindet, Y $-OR_1-$ oder $-NHR_1-$, worin das Heteroatom des Restes Y mit der –CO-Gruppe verbunden ist, und $R_1$ Alkylen mit 2–6 C-Atomen darstellen.

Die Verbindungen der Formel Ia und IIa eignen sich zur Homopolymerisation oder zur Copolymerisation mit anderen äthylenisch ungesättigten Comonomeren, insbesondere solchen der weiter unten angegebenen Art.

Als Beispiele von Ausgangspolymeren, die sich mit Verbindungen der Formel Ib und IIb umsetzen lassen, seien erwähnt: Polyacrylsäure, Polymethacrylsäure, Copolymere aus diesen Säuren und anderen äthylenisch ungesättigten Monomeren, Copolymere aufgebaut aus Maleinsäureanhydrid und äthylenisch ungesättigten Monomeren, wie Methylvinyläther, Äthylen, Styrol, Hexen-1, Decen-1, Tetradecen-1 und Octadecen-1, Polymere mit freien Hydroxylgruppen, wie Homo- und Copolymere von Acrylsäure und Methacrylsäurehydroxyalkylestern, Polyvinylalkohole, native und regenerierte Cellulose, Cellulosederivate, Hydroxyalkylcellulose, Polyäther mit freien –OH-Gruppen, Phenol-Formaldehyd-Polykondensate, Polymere mit freien Glycidylgruppen, wie Copolymere auf der Basis von Acryl- und Methacrylsäureglycidylestern, Polyäthylenimine und Polymere mit freien seitenständigen Aminogruppen, z.B. Polyp-aminostyrol.

Bevorzugt sind erfindungsgemässe Polymere mit einem Durchschnittsmolekulargewicht von etwa 10 000 bis 1 000 000, die einerseits wiederkehrende Strukturelemente mindestens einer der Formeln IIIa bis XIa

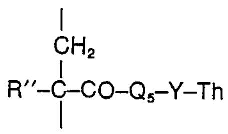 (IIIa),

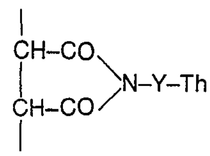 (IVa),

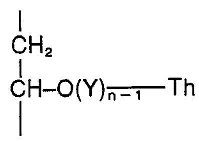

(Va),

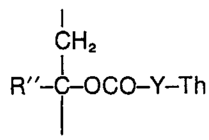

(VIa),

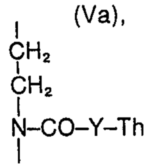

(VIIa),

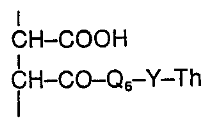

(VIIIa),

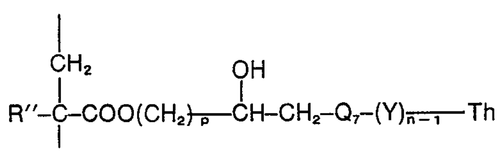 (IXa),

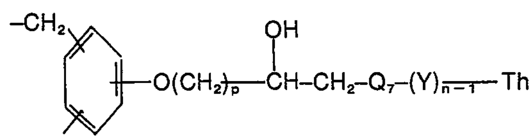 (Xa),

oder 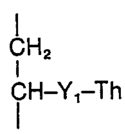 (XIa),

und andererseits wiederkehrende Strukturelemente mindestens einer der Formeln IIIb bis XIIIb

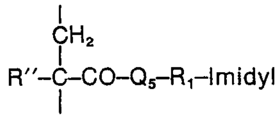 (IIIb),

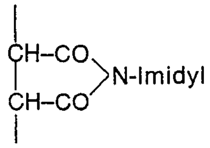 (IVb),

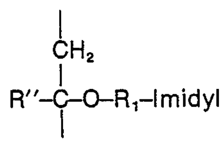

(Vb),

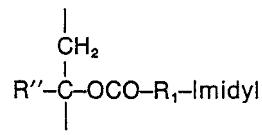

(VIb),

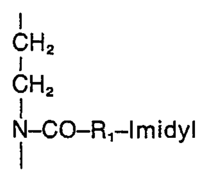

(VIIb),

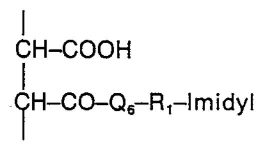

(VIIIb),

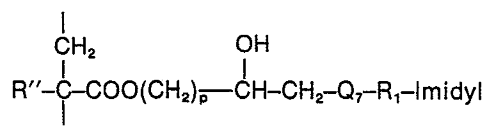

(IXb),

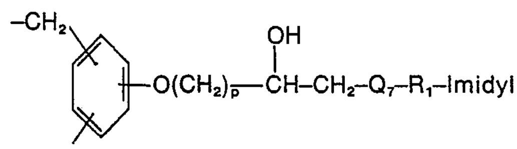

(Xb),

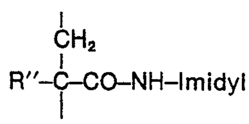

(XIb),

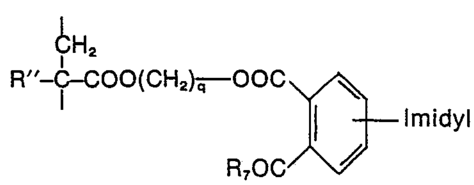

(XIIb) oder

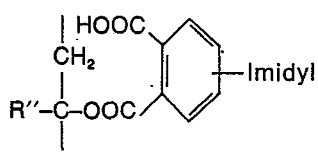

(XIIIb)

aufweisen, worin «Th» einen Rest der Formel I'

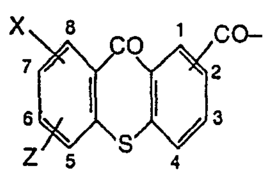

(I')

und «Imidyl» einen Rest der Formel II darstellen, X, Y, Z, $R_1$ und n die unter Formel I angegebene Bedeutung haben,

$Q_5$ –O–, –S– oder –NH–,

$Q_6$ –O–, –S–, –NH– oder –N(R')–,

$Q_7$ –OCO–, –O–, –S–, –NH– oder –N(R')–,

R' Alkyl mit 1–5 C-Atomen,

R'' Wasserstoff oder Methyl,

$R_7$ –OH oder $-O^-M^+$,

$M^+$ ein Alkalimetall-, Pyridinium- oder Trialkylammoniumkation mit 3–24 und insbesondere 3–12 C-Atomen,

p die Zahl 1 oder 2,

q eine ganze Zahl von 2–4,

$Y_1$ $-OR_1'-$, $-SR_1'-$ oder $-NHR_1'$ worin das Heteroatom des Restes $Y_1$ mit der -CO-Gruppe verbunden ist, und $R_1'$ gegebenenfalls verzweigtes Alkylen mit insgesamt 2–23 C-Atomen und 2–13 C-Atomen in der Hauptkette oder Phenylen bedeuten.

Handelt es sich bei den erfindungsgemässen Polymeren um Copolymere mit anderen ungesättigten Verbindungen, so bestehen diese bevorzugt

aus wiederkehrenden Strukturelementen mindestens einer der Formeln IIIa bis XIa und mindestens einer der Formeln IIIb bis XIIIb und aus wiederkehrenden Strukturelementen der Formel XIV

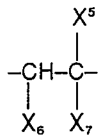 (XIV),

worin $X_6$ Wasserstoff, $X_5$ Wasserstoff, Chlor oder Methyl, $X_7$ Wasserstoff, Methyl, Chlor, –CN, –COOH, –$CONH_2$, Phenyl, Methylphenyl, Methoxyphenyl, Cyclohexyl, Pyridyl, Imidazolyl, Pyrrolidyl, –COO-Alkyl mit 1–12 C-Atomen im Alkylteil, –COO-Phenyl,

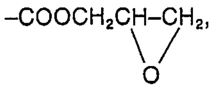

–COO-Alkylen–OH mit 1–3 C-Atomen im Alkylenteil, –OCO-Alkyl mit 1–4 C-Atomen im Alkylteil, –OCO-Phenyl, –CO-Alkyl mit 1–3 C-Atomen im Alkyl, Alkoxy mit 1–20 C-Atomen oder Phenoxy, oder $X_5$ Wasserstoff und $X_6$ und $X_7$ zusammen die Gruppierung

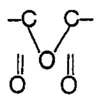

oder je –COOH oder –COO-Alkyl mit 1–6 C-Atomen im Alkyl darstellen. Bevorzugt stellen $X_4$ und $X_6$ je Wasserstoff, $X_5$ Wasserstoff oder Methyl und $X_7$ –$OCOCH_3$, –COOH oder –COOAlkyl mit 1–8 C-Atomen im Alkyl dar oder $X_5$ und $X_6$ bedeuten je Wasserstoff und $X_7$ stellt –CN, Chlor, Phenyl oder Alkoxy mit 1–6 C-Atomen, besonders Methoxy, dar.

In den obigen Formeln IIIa bis XIa, IIIb bis XIIIb und I' haben $G_1$, $G_2$, X, Z, n, Y und $R_1$ mit Vorteil die im Vorangehenden angegebenen bevorzugten Bedeutungen und die Carbonylgruppe in Formel I' ist bevorzugt in 1- oder 3-Stellung an den Benzolring gebunden. Besonders bevorzugt sind Polymere mit widerkehrenden Strukturelementen mindestens einer der Formeln IIIa, Va, VIa, VIIIa oder XIa und wiederkehrenden Strukturelementen mindestens einer der Formeln IIIb, Vb, VIb oder VIIIb und gegebenenfalls wiederkehrenden Strukturelementen der Formel XIV und vor allem Polymere mit wiederkehrenden Strukturelementen mindestens einer der Formeln IIIa und VIIIa und wiederkehrenden Strukturelementen mindestens einer der Formeln IIIb und VIIIb sowie gegebenenfalls wiederkehrenden Strukturelementen der Formel XIV, worin R'' Wasserstoff oder Methyl, $Q_5$ –O–, $Q_6$ –O– oder –NH–, n die Zahl 1 oder 2, Y –$OR_1$– oder –$NHR_1$–, worin das Heteroatom des Restes Y mit der –CO-Gruppe verbunden ist, $R_1$ Alkylen mit 2–6 C-Atomen , X Wasserstoff, Z Wasserstoff oder in 7-Stellung gebundenes Methyl oder Methoxy, $X_6$ Wasserstoff, $X_5$ Wasserstoff oder Methyl und $X_7$ –$OCOCH_3$, –COOH oder –COOAlkyl mit 1–8 C-Atomen im Alkyl, oder $X_5$ und $X_6$ je Wasserstoff und $X_7$ –CN, Chlor, Phenyl oder Alkoxy mit 1–6 C-Atomen, besonders Methoxy, bedeuten und die Carbonylgruppe in Formel I' in 1- oder 3-Stellung an den Benzolring gebunden ist. Speziell bevorzugt sind Polymere, die wiederkehrende Strukturelemente der Formeln IIIa von IIIb sowie wiederkehrende Strukturelemente der Formel XIV aufweisen, worin R'' Methyl, $Q_5$ –O–, Y –O–$CH_2CH_2$–, wobei das Sauerstoffatom des Restes Y mit der –CO-Gruppe verbunden ist, $R_1$ –$CH_2CH_2$–, $X_5$ und $X_6$ je Wasserstoff und $X_7$ –COO–$CH_2CH_3$ bedeuten, der Rest «Th» für die Gruppe

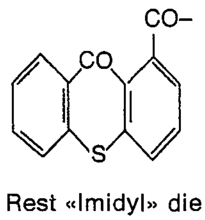

steht und der Rest «Imidyl» die Gruppe

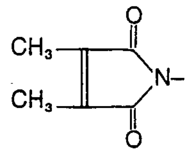

bedeutet, und Polymere, die wiederkehrende Strukturelemente der Formel IIIa und IIIb sowie wiederkehrende Strukturelemente der Formel XIV aufweisen, worin R'' Methyl, $Q_5$ –O–, Y –O–$CH_2CH_2$–, wobei das Sauerstoffatom des Restes Y mit der –CO-Gruppe verbunden ist, $R_1$ –$CH_2CH_2$–, $X_5$ Wasserstoff, $X_6$ Methyl und $X_7$ –COO-n-Butyl oder –COOH bedeuten, der Rest «Th» für die Gruppe

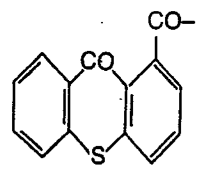

steht und der Rest «Imidyl» die Gruppe

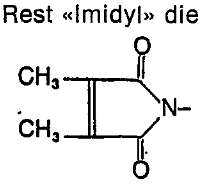

bedeutet.

Polymere, die einerseits wiederkehrende Strukturelemente mindestens einer der Formeln IIIa, IVa, Va oder XIa und andererseits wiederkehrende Strukturelemente mindestens einer der Formeln IIIb, IVb, Vb, VIb, XIb oder XIIb aufweisen, können dadurch erhalten werden, dass man eine Verbindung der Formel Ia, worin X, Y Z und n die oben angegebene Bedeutung haben und $Q_1$ bei n = 1 –OCH=$CH_2$ und bei n = 2
–OCO–C(R'')=$CH_2$, –SCO–C(R'')=$CH_2$,
–NHCO–C(R'')=$CH_2$, –OCH=$CH_2$

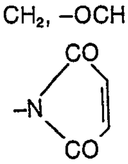

oder, wenn $R_1$ Alkylen oder Phenylen darstellt, auch $-CH=CH_2$ bedeutet, und eine Verbindung der Formel IIa, worin für $R_1$ und n das oben Angegebene gilt und $Q_2$ bei n = 1

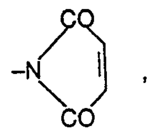

,

$-NHCO-C(R'')=CH_2$ oder

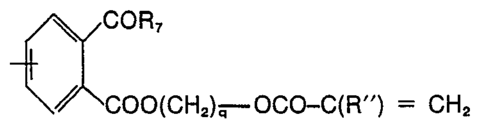

und bei n = 2

$-OCO-C(R'')=CH_2$, $-SCO-C(R'')=CH_2$, $-NHCO-C(R'')=CH_2$, $-O-C(R'')=CH_2$ oder $-COO-C(R'')=CH_2$ bedeutet, gegebenenfalls in Gegenwart eines äthylenisch ungesättigten Comonomeren, besonders solchen der Formel XIVa

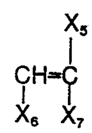

(XIVa),

polymerisiert, wobei $X_5$ bis $X_7$, R'', $R_7$ und q die oben angegebene Bedeutung haben und in Bezug auf die Molverhältnisse der Reaktionskomponenten das im Vorangehenden Erwähnte gilt.

Polymere, die einerseits wiederkehrende Strukturelemente mindestens einer der Formeln IIIa, VIa, VIIa, VIIIa, IXa oder Xa und andererseits wiederkehrende Strukturelemente mindestens einer der Formeln IIIb, VIb, VIIb, VIIIb, IXb, Xb oder XIIIb aufweisen, können dadurch erhalten werden, dass man gleichzeitig oder stufenweise

i) eine Verbindung der Formel Ib oder IIb, worin $G_1$, $G_2$, X, Z, $R_1$ und Y die angegebene Bedeutung haben und $Q_3$ und $Q_4$ bei n = 2 unabhängig voneinander -OH, -SH oder $-NH_2$ bedeuten, mit einem Polymeren mit wiederkehrenden Strukturelementen der Formel III

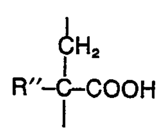

(III),

ii) eine Verbindung der Formel Ib oder IIb, worin $G_1$, $G_2$, X, Z, $R_1$ und Y die angegebene Bedeutung haben, $Q_3$ -COOH oder -COCl (n = 2) und $Q_4$ bei n = 1

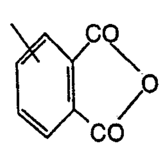

und bei n = 2 -COOH oder -COCl bedeuten, mit einem Polymeren mit wiederkehrenden Strukturelementen der Formel VI oder VII

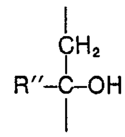

(VI) oder

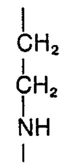

(VII),

iii) eine Verbindung der Formel Ib oder IIb, worin $G_1$, $G_2$, X, $R_1$, Z und Y die angegebene Bedeutung haben, n = 2 ist und $Q_3$ -OH, -SH, $-NH_2$, -NHR' oder -NCO und $Q_4$ -OH, -SH, $-NH_2$ oder -NHR' bedeuten, mit einem Polymeren mit wiederkehrenden Strukturelementen der Formel VIII

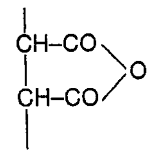

(VIII),

iv) eine Verbindung der Formel Ib und/oder IIb, worin $G_1$, $G_2$, X, Z, $R_1$ und Y die angegebene Bedeutung haben, n = 2 ist und $Q_3$ bzw. $Q_4$ -OH, -SH, $-NH_2$, -NHR' oder -COOH bedeuten, mit einem Polymeren mit wiederkehrenden Strukturelementen der Formel IX oder X

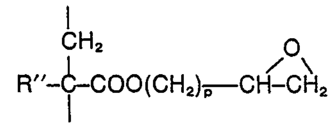

(IX) oder

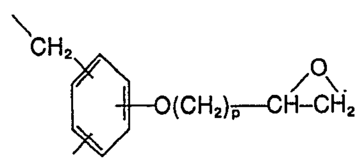

(X),

worin p und R'' die oben angegebene Bedeutung haben, zur Reaktion bringt, wobei in Bezug auf die Molverhältnisse der Reaktionskomponenten das im Vorangehenden Gesagte gilt.

Polymere mit wiederkehrenden Strukturelementen der Formel IXa, worin p die Zahl 1 darstellt, können auch dadurch erhalten werden, dass man eine Verbindung der Formel Ib, worin X, Z, Y und n die angegebene Bedeutung haben und $Q_3$

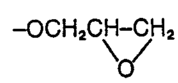

darstellt, mit einem Polymeren mit wiederkehrenden Strukturelementen der Formel III

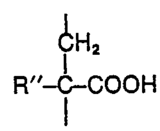

(III)

zur Reaktion bringt, wobei in Bezug auf die Molverhältnisse der Reaktionskomponenten das zuvor Angegebene gilt.

Für den Einbau in bestehende Polymere können wahlweise auch Copolymere, z.B. Polymere mit verschiedenen wiederkehrenden Strukturelemen-

ten der Formeln III, VI bis X und XIV, mit Verbindungen der Formel Ib und IIb mit entsprechenden funktionellen Gruppen eingesetzt werden.

Der Einbau der Thioxanthon- und Imidylgruppierungen in bestehende Polymerketten mittels Kondensations- oder Additionsreaktion kann auf an sich bekannte Weise erfolgen, zweckmässig bei Temperaturen von etwa −50 °C bis +150 °C. Die Umsetzung wird vorzugsweise in einem inerten organischen Lösungsmittel oder einem Lösungsmittelgemisch durchgeführt, für Kondensationsreaktionen bevorzugt bei Temperaturen von etwa −20 °C bis +100 °C. Additionsreaktionen werden zweckmässig bei erhöhter Temperatur, im allgemeinen bei Temperaturen zwischen etwa 80 und 120 °C oder bei Rückflusstemperatur vorgenommen. Geeignete Lösungsmittel zur Durchführung der Kondensations- und Additionsreaktionen sind z. B.: aliphatische oder cyclische Ketone, wie Aceton, Methyläthylketon, Isopropylmethylketon, Cyclohexanon, Cyclopentanon und γ-Butyrolacton; cyclische Äther, wie Tetrahydrofuran, Tetrahydropyran oder Dioxan; cyclische Amide, wie N-Methyl-2-pyrrolidon, N-Äthyl-2-pyrrolidon oder N-Methyl-ε-caprolactam; N,N-Dialkylamide von aliphatischen Monocarbonsäuren mit 1–3 C-Atomen im Säureteil, wie N,N-Dimethylformamid, N,N-Dimethylactamid, N,N-Diäthylacetamid, N,N-Dimethylmethoxyacetamid; Pyridin und Pyridinbasen oder tertiäre Amine, vor allem Trialkyl- und Dialkylbenzylamine mit bevorzugt 1–4 C-Atomen in den Alkylteilen, z. B. Triäthylamin und Diäthylbenzylamin; Dialkylsulfoxide, wie Dimethyl- und Diäthylsulfoxid. Bevorzugte Lösungsmittel für Kondensationsreaktionen sind cyclische Amide und N,N-Dialkylamide der vorerwähnten Art, besonders N-Methyl-2-pyrrolidon, N,N-Dimethylformamid und N,N-Dimethylacetamid. Für Additionsreaktionen werden cyclische Äther und cyclische Ketone, vor allem Tetrahydrofuran und Cyclohexanon, sowie Pyridin bevorzugt.

Die Polymerisation von Verbindungen der Formel Ia und IIb sowie deren Copolymerisation mit anderen äthylenisch ungesättigten Monomeren, z. B. solchen der Formel XIVa, können ebenfalls auf an sich bekannte Weise vorgenommen werden, z. B. in Gegenwart üblicher kationischer und anionischer Initiatoren. Bevorzugt ist die radikalische Polymerisation. Dabei verwendet man zweckmässig etwa 0,01 bis 5 Gew.-%, vorzugsweise 0,01 bis 1,5 Gew.-%, bezogen auf das Gesamtgewicht der Monomeren, an sich bekannter Radikalinitiatoren, wie anorganische oder organische Peroxide oder Azoverbindungen, z. B. Wasserstoffperoxid, Kaliumperoxidisulfat, tert.-Butylhydroperoxid, Di-tert-butylperoxid, Peressigsäure, Benzoylperoxid, Diacylperoxide, Cumolhydroperoxid, tert.-Butylperbenzoat, tert.-Alkylperoxicarbonate und α,α'-Azoisobutyronitril. Die Reaktionstemperaturen für die radikalische Polymerisation liegen im allgemeinen zwischen etwa 30 und 100 °C. Die radikalische Polymerisation kann aber auch in der Kälte durchgeführt werden, wozu man auch Redoxsysteme in den oben genannten Konzentrationen verwenden kann, beispielsweise Gemische aus Peroxiden, wie Wasserstoffperoxid, und einem Reduktionsmittel, wie zweiwertige Eisenionen. Die Polymerisation kann in homogener Phase, z. B. in Substanz (Blockpolymerisation) oder in Lösung oder in heterogener Phase, d. h. als Fällungspolymerisation, Emulsions- oder Suspensionspolymerisation, erfolgen. Bevorzugt ist die Polymerisation in Lösung. Geeignete Lösungsmittel sind solche der bei der Kondensations- bzw. Additionsreaktion erwähnten Art sowie: halogenierte aliphatische Kohlenwasserstoffe, wie Methylenchlorid, Chloroform, Tetrachloräthan und Tetrachloräthylen; Alkylester von aliphatischen Monocarbonsäuren mit insgesamt 2–6 C-Atomen, wie Ameisen- oder Essigsäuremethyl-, -äthyl- und -n-butylester; Äthylenglykoldialkyläther mit 1–4 C-Atomen in den Alkylteilen, wie Äthylenglykoldimethyl-, -diäthyl- und -di-n-butyläther.

Die Verbindungen der Formel IIa und IIb sind an sich bekannt oder können nach den in der deutschen Offenlegungsschrift 2 626 795 beschriebenen Verfahren hergestellt werden. Die Verbindungen der Formel Ia und Ib können dadurch hergestellt werden, dass man

a) eine Verbindung der Formel 1)

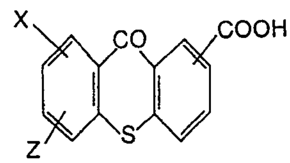

(1),

einen $C_{1-6}$-Alkylester einer Verbindung der Formel 1) oder ein Säurechlorid einer Verbindung der Formel 1) mit einer Verbindung der Formel 2a)

$$H(Y)_{\overline{n-1}}-Q' \qquad (2a)$$

oder, bei $Q' = -NH_2$ oder $-NHR'$, einem Salz einer Verbindung der Formel 2a) zu einer Verbindung der Formel Ic)

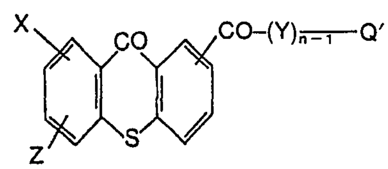

(Ic)

bzw. entsprechenden Salzen davon umsetzt,

b) eine Verbindung der Formel 1) oder einen $C_{1-6}$-Alkylester einer Verbindung der Formel 1) mit einer Verbindung der Formel 2b)

$$CH_2=CH-OCO-R' \qquad (2b)$$

zu einer Verbindung der Formel Id

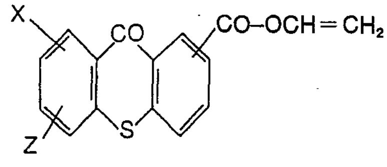

(Id)

umsetzt oder

c) ein Säurechlorid einer Verbindung der Formel 1) zuerst mit einem Salz einer Verbindung der Formel 2c)

$$H\text{–}Y\text{–}NH_2 \quad (2c)$$

zum entsprechenden Salz einer Verbindung der Formel 3)

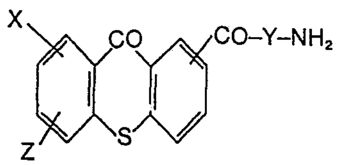

(3)

umsetzt und dieses Salz in Gegenwart eines inerten organischen Lösungsmittels mit Phosgen zu einer Verbindung der Formel Ie

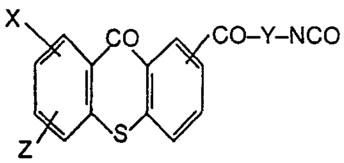

(Ie)

umsetzt, wobei X, Y, Z, R′ und n die unter Formel I bzw. Ib angegebene Bedeutung haben, Q′, bei n = 1

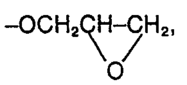

$-OCH_2\text{–}COOH$, $-OCH_2CH=CH_2$, $-SCH_2CH=CH_2$ oder $-NHCH_2CH=CH_2$ und bei n = 2, $-OH$, $-SH$, $-NH_2$, $-NHR'$, $-SO_3H$, $-COOH$, $-OCO\text{–}C(R'')=CH_2$, $-SCO\text{–}C(R'')=CH_2$, $-NHCO\text{–}C(R'')=CH_2$,

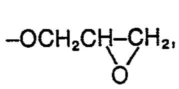, 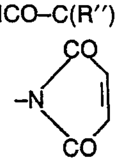

oder, wenn $R_1$ Alkylen oder Phenylen bedeutet, auch $-CH=CH_2$ und R″ Wasserstoff oder Methyl darstellen, und gegebenenfalls anschliessend die Gruppe X in den Verbindungen der Formeln Ic, Id oder Ie in eine davon verschiedene Gruppe X und/oder die Gruppe Q′ = $-COOH$ in Formel Ic durch Behandlung mit geeigneten Chlorierungsmitteln in die Gruppe $-COCl$ überführt. Als Salze von Verbindungen der Formel 2a, 2c, Ic und 3) (Q′ = $-NH_2$ oder $-NHR'$) kommen insbesondere Salze mit anorganischen Säuren, wie HCl, $H_2SO_4$ oder Salpetersäure, in Betracht. Salze von Verbindungen der Formel Ic können auf bekannte Weise durch Zusatz von geeigneten Basen in die entsprechenden Amine übergeführt werden.

Als Chlorierungsmittel können z.B. Thionylchlorid, $PCl_5$ oder Oxalylchlorid verwendet werden. Definitionsgemässe Alkylester von Verbindungen der Formel 1) werden zweckmässig aus den entsprechenden Säurechloriden hergestellt.

Die obigen Umsetzungen können auf an sich bekannte Weise und je nach Art der Reaktionskomponenten mit oder ohne Zusatz inerter organischer Lösungsmittel, wie Dioxan, Benzol, Toluol, Methylenchlorid oder Chloroform, durchgeführt werden. Säurechloride von Verbindungen der Formel 1) werden mit Alkoholen oder Thiolen der Formel 2a) im allgemeinen bei Temperaturen zwischen etwa 25–80 °C umgesetzt. Als Lösungsmittel verwendet man zweckmässig einen Überschuss des entsprechenden Alkohols oder Thiols. Die Umsetzung der Säurechloride von Verbindungen der Formel 1) mit Aminen der Formel 2a) erfolgt mit Vorteil bei Temperaturen zwischen etwa 0 und 40 °C. Die Umsetzung der freien Säuren der Formel 1) mit Alkoholen der Formel 2a) wird zweckmässig unter azeotroper Wasserabscheidung und unter Zusatz katalytischer Mengen Säure, wie $H_2SO_4$ oder p-Toluolsulfonsäure, oder in Gegenwart wasserabspaltender Mittel, wie HCl-Gas oder konzentrierter Schwefelsäure, durchgeführt. Als Schleppmittel verwendet man dabei bevorzugt Benzol, Toluol oder Chloroform. Die Umesterung von Alkylestern von Verbindungen der Formel 1) erfolgt mit Vorteil unter Zusatz von Säuren, wie HCl oder $H_2SO_4$, Aluminiumalkoholaten, basischen oder sauren Ionenaustauschern. Die Umsetzung von Verbindungen der Formel 1) oder deren Alkylestern mit Verbindungen der Formel 2b wird zweckmässig in Gegenwart von Katalysatoren, wie $HgCl_2$, $Li_2(PdCl_4)$ oder $PdCl_2$, vorgenommen.

Einige Verbindungen der Formel Ia oder Ib können auch nach abgeänderten Verfahren, z.B. wie folgt hergestellt werden: 1) Verbindungen der Formel Ia bzw. Ib, worin Y $-OR_1-$, wobei das –O– mit der –CO-Gruppe verbunden ist, $Q_1$ bzw. $Q_3$ bei n = 1

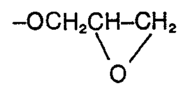

oder $-OCH_2CH=CH_2$ und bei n = 2 $-OH$, $-SH$, $-NH_2$, $-NHR'$, $-OCO\text{–}C(R'')=CH_2$, $-NHCO\text{–}C(R'')=CH_2$, $-SCO\text{–}C(R'')=CH_2$, $-CH=CH_2$, $-OCH=CH_2$ oder

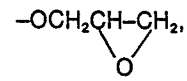

darstellen und X und Z die oben angegebene Bedeutung haben, durch Umsetzung eines Alkalimetall- oder Erdalkalimetallsalzes einer Verbindung der Formel 1) mit einem Halogenid der Formel 4)

$$Hal\text{–}(R_1)_{n-1}\text{–}Q'' \quad (4),$$

gegebenenfalls in Gegenwart einer Base, wobei Hal ein Halogenatom, besonders Chlor oder Brom, und Q″ bei n = 1

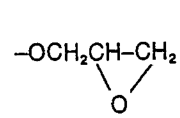

oder $-CH_2CH=CH_2$ und bei n = 2 $-OH$, $-SH$, $-NH_2$, $-NHR'$, $-OCO\text{–}C(R'')=CH_2$, $-NHCO\text{–}C(R'')=CH_2$, $-SCO\text{–}C(R'')=CH_2$, $-CH=CH_2$, $-OCH=CH_2$ oder

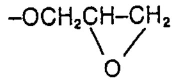

bedeuten und $R_1$ und n die oben angegebene Bedeutung haben, und gegebenenfalls anschliessende Überführung der Gruppe X in eine davon verschiedene Gruppe X.

2) Verbindungen derFormel Ia, worin X, Y und Z die angebene Bedeutung haben, n die Zahl 2 und $Q_1$

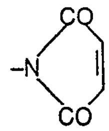

darstellen, durch Umsetzung einer Verbindung der Formel 3) mit Maleinsäureanhydrid, Cyclisierung der erhaltenen Amidcarbonsäure in an sich bekannter Weise, z.B. in Gegenwart von Acetanhydrid und Natriumacetat, und gegebenenfalls anschliessende Überführung der Gruppe X in eine davon verschiedene Gruppe X.

3) Durch Umsetzung von Verbindungen der Formel Ib, worin X, Y und Z die angegebene Bedeutung haben, n die Zahl 2 und $Q_3$ –OH, –SH oder $-NH_2$ bedeuten, mit einem Halogenid der Formel 5)

$$Hal{-}CO{-}C(R'')=CH_2 \quad (5),$$

worin Hal ein Halogenatom, besonders Chlor oder Brom, bedeutet und R″ Wasserstoff oder Methyl ist.

4) Verbindungen der Formel Ib mid n = 1 oder 2 und $Q_3$ =

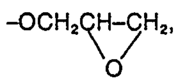

durch Umsetzung eines Alkalimetall- oder Erdalkalimetallsalzes einer Verbindung der Formel 6)

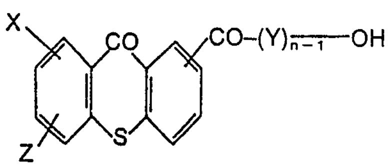

(6),

mit Epichlorhydrin oder Epibromhydrin, gegebenenfalls in Gegenwart einer Base, wobei n, X, Y und Z die oben angegebene Bedeutung haben.

Als Alkalimetall- und Erdalkalimetallsalze von Verbindungen der Formel a) bzw. 6) setzt man bei den obigen Reaktionen z.B. Calcium- oder Bariumsalze und insbesondere Natrium- oder Kaliumsalze ein. Als Basen können z.B. Amine, wie Diäthylamin und Triäthylamin, eingesetzt werden. Die Umsetzungen 1) und 4) können auch mittels Phasentransfer-Katalyse vorgenommen werden, z.B. in Gegenwart von Tetraalkyl- oder Trialkylbenzylammoniumhalogeniden mit je 1–4 C-Atomen in den Alkylgruppen, und $K_2CO_3$ oder $Na_2CO_3$.

Die Ausgangsverbindungen der Formel 2a), 2b) und 2c) sind bekannt und können nach an sich bekannten Methoden hergestellt werden. Die Verbindungen der Formel 1) sind teilweise ebenfalls bekannt. Sie können auf an sich bekannte Weise hergestellt werden (vgl. deutsche Offenlegungsschrift 2 344 799 und US Patentschrift 4 101 558), z.B. durch Cyclisieren einer Verbindung der Formel 7a) oder 7b)

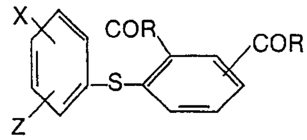

oder

(7a)

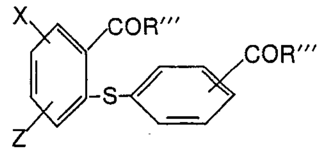

(7b),

worin X und Z die oben angegebene Bedeutung haben und R und R‴ –OH oder Chlor bedeuten, oder, wenn sich die Gruppen –COR in ortho-Stellung zueinander befinden, die beiden R zusammen –O– darstellen, unter gleichzeitiger Hydrolyse von Chloratomen R oder R‴.

Ausgangsprodukte der Formel 1), worin X Wasserstoff, Halogen, –CN, $-NO_2$, Phenylsulfonyl, Alkylsulfonyl, Alkyl, Alkoxy, Alkylthio oder N,N-Dialkylamino mit je 1–4 C-Atomen in den Alkylteilen bedeutet und Z die angegebene Bedeutung hat, können auch dadurch hergestellt werden, dass man

α) eine Verbindung der Formel 8a)

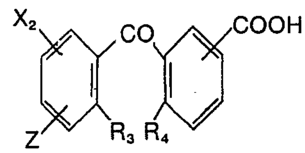

(8a),

worin Z die angegebene Bedeutung hat, $X_2$ Wasserstoff, Halogen, –CN, $-NO_2$, Phenylsulfonyl, Alkylsulfonyl, Alkyl, Alkoxy, Alkylthio oder N,N-Dialkylamino mit je 1–4 C-Atomen in den Alkylteilen, eines von $R_3$ und $R_4$ eine Mercaptogruppe und das andere eine abspaltbare Gruppe bedeuten, cyclisiert oder

β) eine Verbindung der Formel 8b)

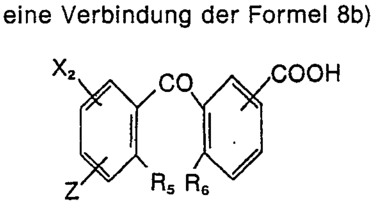

(8b)

mit einem anorganischen Sulfid zu einer Verbindung der Formel 1) cyclisiert, wobei $X_2$ und Z die oben angegebene Bedeutung haben und $R_5$ und $R_6$ unabhängig voneinander eine abspaltbare Gruppe darstellen.

Schliesslich können Ausgangsverbindungen der Formel 1), worin X Wasserstoff, Halogen,

$-NO_2$, Phenylsulfonyl, Alkylsulfonyl, Alkyl, Alkoxy, Alkylthio, N,N-Dialkylamino oder –CO-Alkyl mit je 1–4 C-Atomen in den Alkylteilen darstellt und Z die angegebene Bedeutung hat, auch dadurch erhalten werden, dass man eine Verbindung der Formel 9)

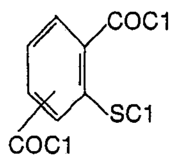

(9)

in Gegenwart eines Friedel-Crafts-Katalysators mit einer Verbindung der Formel 10)

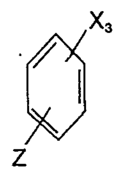

(10)

umsetzt, und den entstandenen Komplex zu einer Verbindung der Formel 1) zersetzt, wobei $X_3$ Wasserstoff, Halogen, $-NO_2$, Phenylsulfonyl, Alkylsulfonyl, Alkyl, Alkoxy, Alkylthio, N,N-Dialkylamino oder –CO-Alkyl mit je 1–4 C-Atomen in den Alkylteilen bedeutet und Z die oben angegebene Bedeutung hat

Die Cyclisierung der Verbindungen der Formel 7a) und 7b) wird mit Vorteil in Gegenwart einer Protonensäure oder einer Lewis-Säure vorgenommen. Beispiele geeigneter Protonensäuren sind Polyphosphorsäure, gegebenenfalls im Gemisch mit Phosphoroxichlorid, Chlorsulfonsäure und Schwefelsäure. Geeignete Lewis-Säuren sind z.B. Aluminiumtrichlorid oder Bortrifluorid. Die Ausgangsverbindungen der Formel 7a) und 7b) lassen sich z.B. analog den in der deutschen Offenlegungsschrift 2 344 799 beschriebenen Verfahren durch Umsetzung von geeignet substituierten Thiophenolen oder Derivaten davon, wie Alkalimetall- oder Erdalkalimetallsalzen, mit Nitro- oder Halogenbenzolen herstellen. Dabei müssen das Thiophenol und das Nitro- oder Halogenbenzol zusammen mindestens zwei Gruppen –COR bzw. –COR‴ oder zwei in Gruppen –COR oder –COR‴ überführbare Gruppen, wie Nitrilgruppen, aufweisen, wovon sich eine in ortho-Stellung zur SH-Gruppe bzw. zur Nitrogruppe oder zu einem Halogenatom befinden muss. Geeignete Nitrobenzole sind solche, die neben der Nitrogruppe noch eine oder mehrere elektronenanziehende Gruppen, wie Carbonsäureester-, Carbonsäurechlorid-, Nitril-, Anhydrid- oder Imidgruppen aufweisen. Nach einem bevorzugten Verfahren werden Verbindungen der Formel 7a) durch Umsetzung eines Nitrophthal-, -isophthal- oder- -terephthalsäuredicarbonsäurealkylesters mit einem geeignet substituierten Thiophenol und anschliessende Verseifung des erhaltenen Dicarbonsäurealkylesters einer Verbindung der Formel 7a) hergestellt. Als abspaltbare Gruppen $R_3$ bis $R_6$ kommen vor allem Halogenatome, Nitro-, Arylsulfonyl- und Sulfinylgruppen in Betracht. Bevorzugte abspaltbare Gruppen $R_3$ bis $R_6$ sind Halogenatome, besonders Chlor, und Nitrogruppen.

Als anorganisches Sulfid zur Umsetzung mit Verbindungen der Formel 7b) verwendet man mit Vorteil Alkalimetall- oder Erdalkalimetallsulfide oder -hydrosulfide, bevorzugt Natriumsulfid. Die Ausgangsprodukte der Formeln 8a) und 8b) können auf an sich bekannte Weise durch Friedel-Crafts-Reaktion von entsprechend substituierten Acylhalogeniden mit geeignet substituierten nucleophilen aromatischen Verbindungen erhalten werden.

Die Kondensation der Verbindungen der Formel 9) mit den Verbindungen der Formel 10) in Gegenwart von Friedel-Crafts-Katalysatoren, besonders Aluminiumtrichlorid, wird zweckmässig in organischem Medium bei Temperaturen zwischen etwa 10 und 80 °C durchgeführt. Nach Beendigung der Umsetzung kann der entstandene Komplex durch Eingiessen in ein Wasser/Eis-Gemisch oder durch Zugabe von verdünnter Mineralsäure, wie Salzsäure, oder von wässrigen Alkalimetall- oder Erdalkalimetallhydroxid-Lösungen, wie Natrium-, Kalium-, Barium- oder Calciumhydroxid, zersetzt werden.

Die Überführung von Gruppen X, $X_2$ oder $X_3$ in davon verschiedene Gruppen X kann auf an sich bekannte Weise vorgenommen werden. So lassen sich beispielsweise Nitrogruppen X, $X_2$ oder $X_3$ nach an sich bekannten Methoden zu Aminogruppen reduzieren, die ihrerseits in Halogenatome, –CN, Alkoxy- oder N,N-Dialkylaminogruppen übergeführt werden können. Cyanogruppen X oder $X_2$ lassen sich in Gruppen X = –CO-Alkyl umwandeln. Durch Alkylsulfonyl- oder Phenylsulfonylgruppen substituierte Thioxanthone der Formel Ia und Ib lassen sich z.B. durch Umsetzung der entsprechenden Nitroverbindungen mit Alkalimetall-alkyl- oder -phenylsulfinaten herstellen.

Die erfindungsgemässen Polymeren können z.B. zur Erzeugung von hoch lichtempfindlichen Bildmaterialien, wie Reprovorlagen, oder zur Herstellung von Druckplatten für das Offsetdruckverfahren, zur Herstellung von Photooffset-Lacken, für die unkonventionelle Photographie, z.B. zur Herstellung von photographischen Bildern mittels Photopolymerisation oder Photovernetzung verwendet werden. Sie finden insbesondere Anwendung als sogenannte Photoresists zur Herstellung von gedruckten Schaltungen nach an sich bekannten Methoden. Dabei wird die mit der lichtempfindlichen Schicht versehene Seite der Leiterplatte durch ein das Leiterbild aufweisendes Strich- oder Raster-Dianegativ belichtet und dann entwickelt, worauf man die unbelichteten Stellen der Schicht durch Entwicklungsflüssigkeit herausholt.

Die erfindungsgemässen lichtvernetzbaren Polymeren, bei denen die Thioxanthongruppierungen, d.h. der Sensibilisator, kovalent an das Polymerrückgrat gebunden sind, zeichnen sich durch eine hohe Photoempfindlichkeit der lichtvernetzbaren Gruppen aus. Zudem können durch diesen kovalenten Einbau der Sensibilisatormoleküle in die lichtvernetzbaren Polymeren die Probleme

der Löslichkeit und des Entmischens im Polymeren vermieden werden.

A. Herstellungsbeispiele

Beispiel 1

In einem unter einem Stickstoffstrom stehenden Dreihalskolben werden 27,14 g (0,14 Mol) N-[β-(methacryloyloxy)-äthyl]dimethylmaleinimid [hergestellt gemäss deutscher Offenlegungsschrift 2 626 795], 2,86 g (0,029 Mol) Acrylsäureäthylester, 0,9 g (0,0027 Mol) Thioxanthon-1-carbonsäure-β-(methacryloyloxy)-äthylester und 100 ml Tetrahydrofuran vorgelegt. Bei 66 °C wird unter Inertgasatmosphäre eine Lösung von 0,15 g Azoisobutyronitril in 20 ml Tetrahydrofuran zugegeben, und das Reaktionsgemisch wird 16 Stunden am Rückfluss (66 °C) gerührt. Die Polymerlösung wird in Diäthyläther ausgefällt, und das Polymere wird im Vakuum bei 40 °C getrocknet. Man erhält 25,3 g (81,9% d.Th.) Polymer (Polymer Nr. 1).

Grenzviskosität ηGrenz = 0,35 dl/g in $CHCl_3$ bei 20 °C; durchschnittliches Molekulargewicht = 619 299.

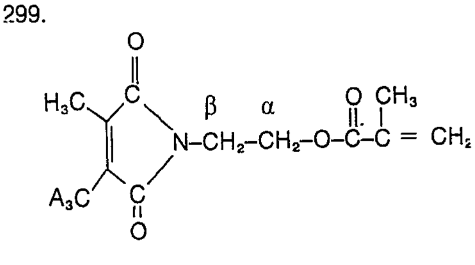

Beispiel 2

In einem unter einem Stickstoffstrom stehenden Dreihalskolben werden 18,58 g (0,078 Mol) N-[β-(methacryloyloxy)-äthyl]-dimethylmaleinimid, 1,96 g (0,0196 Mol) Acrylsäureäthylester, 0,308 g (0,000916 Mol) Thioxanthon-1-carbonsäure-β-(methacryloyloxy)-äthylester und 70 ml Tetrahydrofuran vorgelegt. Bei 66 °C wird in Inertgasatmosphäre eine Lösung von 0,102 g Azoisobutyronitril in 12 ml Tetrahydrofuran zugegeben, und das Reaktionsgemisch wird während 16 Stunden am Rückfluss gerührt (66 °C). Die Polymerlösung wird in Diäthyläther aufgefällt, und das Polymere wird im Vakuum bei 40 °C getrocknet. Man erhält 17,4 g (83,5% d.Th.) Polymer (Polymer Nr. 2). ηGrenz = 0,28 dl/g in $CHCl_3$ bei 20 °C.

Beispiel 3

In einem unter einem Stickstoffstrom stehenden Dreihalskolben werden 27,14 g (0,115 Mol) N-[β-(methacryloyloxy)-äthyl]-dimethylmaleinimid, 2,86 g (0,029 Mol) Acrylsäureäthylester, 0,15 g (0,00045 Mol) Thioxanthon-1-carbonsäure-β-(methacryloyloxy)-äthylester und 100 ml Tetrahydrofuran vorgelegt. Bei 66 °C wird unter Inertgasatmosphäre eine Lösung von 0,15 g Azoisobutyronitril in 20 ml Tetrahydrofuran zugegeben, und das Reaktionsgemisch wird während 16 Stunden am Rückfluss (66 °C) gerührt. Die Polymerlösung wird in Diäthyläther ausgefällt, und das Polymere wird im Vakuum bei 40 °C getrocknet. Man erhält 26,3 g (87,2% d.Th.) Polymer (Polymer Nr. 3). ηGrenz = 0,27 dl/g in $CHCl_3$ bei 20 °C.

Der in den obigen Beispielen 1–3 verwendete Thioxanthon-1-carbonsäure-β-(metharyloyloxy)-äthylester wird wie folgt hergestellt: Aus 7,5 g (0,33 Grammäquivalenten) Natrium, 300 ml Methanol und 36 ml (0,33 Mol) Thiophenol hergestelltes trockenes Natriumthiophenolat wird in 300 ml Dimethylsulfoxid gelöst und mit 80,4 g (0,3 Mol) 3-Nitrophthalsäure-N-phenylimid versetzt. Das Reaktionsgemisch wird 90 Minuten auf 50 °C erhitzt und dann in ein Gemisch von 300 ml Wasser und 300 ml wasserfreie Essigsäure gegossen. Die entstandene Suspension wird abgesaugt und bei 80 °C/13 000 Pa getrocknet. Man erhält 100 g (100% d.Th.) 3-Phenylthiophthalsäure-N-phenylimid 99,4 g (0,3 Mol) 3-Phenylthiophthalsäure-N-phenylimid werden in 1326 ml einer 20%igen Natriumhydroxidlösung suspendiert und unter Rühren während 30 Minuten auf 100 °C erhitzt. Nach dem Abkühlen wird die alkalische Suspension unter Rühren mit 672 ml 37%iger Salzsäure angesäuert. Nach einer Stunde wird die feine Suspension abgesaugt, noch nass in 882 ml 37%iger Salzsäure suspendiert und während einer Stunde zum Rückfluss erhitzt. Das Reaktionsgemisch wird abgekühlt, die entstandene feine Suspension wird abgesaugt und bei 80 °C/13 000 Pa getrocknet. Man erhält 69,4 g (85% d.Th.) 3-Phenylthiophthalsäure. 69 g (0,25 Mol) 3-Phenylthiophthalsäure und 700 ml Polyphosphorsäure werden unter Rühren 90 Minuten auf 200 °C erhitzt, dann abgekühlt und in 3000 ml Wasser verrührt. Nach einer Stunde wird die entstandene Suspension abgesaugt, mit Wasser nachgewaschen und bei 80 °C getrocknet. Das erhaltene Rohprodukt wird in 350 ml N,N-Dimethylformamid heiss gelöst, mit Tierkohle versetzt und filtriert. Das Filtrat wird mit der fünffachen Menge Wasser verdünnt, und die entstandene Suspension wird abfiltriert, mit Wasser nachgewaschen und getrocknet. Man erhält 63 g (98% d.Th.) Thioxanthon-1-carbonsäure; Fp. 259 °C. Die auf diese Weise erhaltene Säure kann direkt weiterverwendet werden. 82 g (0,32 Mol) Thioxanthon-1-carbonsäure werden in 460 ml Thionylchlorid 5 Stunden unter Rückfluss gekocht. Die dabei entstehende dunkle, klare Lösung wird zur Trockne eingedampft. Man erhält 87,5 g (100% d.Th.) Thioxanthon-1-carbonsäurechlorid. 11 g (0,04 Mol) Thioxanthon-1-carbonsäurechlorid und 10,4 g (0,08 Mol) Methacrylsäure-2-hydroxyäthylester werden in 170 ml Dioxan 3 Stunden auf 80 °C erhitzt und anschliessend zur Trockne eingedampft. Der feste Rückstand wird mit 100 ml Wasser verrührt, und der pH der erhaltenen Suspension wird mit einer 3%igen Natriumbicarbonatlösung auf 8 eingestellt. Dann wird das Rohprodukt mit 200 ml Methylenchlorid extrahiert, mit festem Natriumsulfat getrocknet, und das Methylenchlorid wird eingedampft. Der Rückstand wird in 100 ml Methanol gelöst und mit 4 g Tierkohle filtriert. Das auskristallisierte Produkt wird in 1200 ml Diäthyläther gelöst und mit 50 ml 1%iger Natronlauge extrahiert. Die Ätherphase wird mit Wasser gewaschen und mit Natriumsulfat getrocknet. Dann wird die ätherische Lösung mit 0,05 Gew.-% 2,6-Di-tert-butylkresol stabilisiert und eingeengt. Man erhält 7,7 g (52% d. Th.) Thioxanthon-1-carbonsäure-β-(methacryloyloxy)-äthylester; Fp. 112–113 °C. IR-Spektrum (Chloroform): 1740 $cm^{-1}$ (–COOR); 1660 $cm^{-1}$ (–CO–).

Beispiel 4

2,75 g (10 mMol) N-[β-(methacryloyloxy)-äthyl]-dimethylmaleinimid, 1,0 g (7 mMol) Methacrylsäure-n-butylester und 0,25 g (0,68 mMol) Thioxaanthon-1-carbonsäure-β-(methacryloyloxy)-äthylester (II), 1,0 g (11,6 mMol) Methacrylsäure, 0,025 g Azoisobutyronitril und 0,050 g Dodecylmercaptan werden in einem 100 ml Sulfierkolben, der mit Rückflusskühler, Stickstoffeinleitung und Rührer ausgestattet ist, in 20 g Toluol gelöst. Es wird im gelben Licht bei 70 °C während 14 Stunden polymerisiert. Das ausgefallene Polymere (Polymer Nr. 4) wird abfiltriert und am Hochvakuum getrocknet. Zusammensetzung des Polymeren: 34,15 Mol% (I) und 2,32 Mol.% (II). ηGrenz = 0,22 dl/g in $CHCl_3$ bei 20 °C.

Beispiel 5

2,25 g (0,5 mMol) N-[β-(methacryloyloxy)-äthyl]-dimethylmaleinimid, 1,0 g (7 mMol) Methacrylsäure-n-butylester, 0,75 g (2,04 mMol) Thioxanthon-1-carbonsäure-β-(methacryloyloxy)-äthylester (II), 1,0 g (11,6 mMol) Methacrylsäure, 0,025 g Azoisobutyronitril und 0,050 g Dodecylmercaptan werden auf die in Beispiel 4 beschriebene Weise polymerisiert (Polymer Nr. 5). Zusammensetzung des Polymeren: 21,52 Mol.% (I) und 6,77 Mol% (II). ηGrenz = 0,18 dl/g in $CHCl_3$ bei 20 °C.

Beispiel 6

1,8 g (7,6 mMol) N-[β-(methacryloyloxy)-äthyl]-dimethylmaleinimid, 1,0 g (7 mMol) Methacrylsäure-n-butylester, 1,2 g (3,26 mMol) Thioxanthon-1-carbonsäure-β-(methacryloyloxy)-äthylester (II), 1,0 g (11,6 mMol) Methacrylsäure, 0,025 g Azoisobutyronitril und 0,050 g Dodecylmercaptan werden wie in Beispiel 4 beschrieben polymerisiert (Polymer Nr. 6). Zusammensetzung des Polymeren: 25,8 Mol.% (I) und 11,06 Mol.% (II). βGrenz = 0,19 dl/g in $CHCL_3$ bei 20 °C.

Beispiel 7

2 g eines Copolymeren aus Maleinsäureanhydrid und Methylvinyläther (Molverhältnis 1 : 1, durchschnittliches Molekulargewicht ca. 740 000) werden zusammen mit 0,6 g (0,002 Mol) Thioxanthon-1-carbonsäure-β-hydroxyäthylester in 20 ml absolutem Tetrahydrofuran gelöst. Zu dieser Lösung werden 1,08 g N-(β-Hydroxyäthyl)-dimethylmaleinimid [hergestellt gemäss deutscher Offenlegungsschrift 2 626 795] und 0,06 ml trockenes Pyridin gegeben. Die Lösung wird während 72 Stunden unter Lichtausschluss am Rückfluss gekocht. Danach wird auf Zimmertemperatur abgekühlt, und das Reaktionsgemisch wird in einem Liter verdünnter Salzsäure ausgefällt. Man erhält nach dem Trocknen 3 g eines leicht gelblichen Polymerisats (Polymer Nr. 7). ηGrenz = 0,37 dl/g in $CHCl_3$ bei 20 °C.

Beispiel 8

2 g eines Copolymeren aus Äthylen und Maleinsäureanhydrid (Molverhältnis 1 : 1, durchschnittliches Molekulargewicht ca. 20 000) werden zusammen mit 0,75 g (0,0024 Mol) Thioxanthon-1-carbonsäure-β-hydroxyäthylester in 20 ml absolutem Tetrahydrofuran gelöst. Zu dieser Lösung werden 1,352 g N-(β-Hydroxyäthyl)-dimethylmaleinimid und 0,06 ml trockenes Pyridin gegeben. Die Lösung wird während 72 Stunden unter Lichtausschluss am Rückfluss gekocht. Anschliessend wird auf Zimmertemperatur abgekühlt, und das Reaktionsgemisch wird in 1 Liter verdünnter Salzsäure ausgefällt. Man erhält nach dem Trocknen 3,2 g eines gelblichen Polymerisats (Polymer Nr. 8), ηGrenz = 0,31 dl/g in $CHCl_3$ bei 20 °C. Der in den obigen Beispielen 7 und 8 verwendete Thioxanthon-1-carbonsäure-β-hydroxyäthylester kann wie folgt hergestellt werden: 18,4 g (0,06 Mol) Thioxanthon-1-carbonsäurenatriumsalz [hergestellt durch Umsetzung von Thioxanthon-1-carbonsäure mit NaoH], 14,5 g (0,18 Mol) Äthylenchlorhydrin und 0,18 g Diäthylamin werden unter Rückfluss während 4 Stunden auf 130 °C erhitzt. Nach dem Abkühlen der Reaktionsmasse wird diese zweimal mit je 100 ml Dioxan eingedampft. Der Rückstand wird unter Zugabe von Tierkohle aus 1000 ml Methanol umkristallisiert. Man erhält 13,2 g Thioxanthon-1-carbonsäure-β-hydroxyäthylester; Fp. 169 °C. IR-Spektrum (Chloroform): 1750 $cm^{-1}$ (–COOR); 1660 $cm^{-1}$ (–CO–).

Beispiel 9

In einem 100 ml Dreihalskolben werden 3,44 g eines Polymers aus 50 Mol. N-[β-methacryloyloxy)-äthyl]dimethylmaleinimid, 25 Mol% Methacrylsäure-n-butylester und 25 Mol.% Maleinsäure mit 3,12 g (0,1 Mol) Thioxanthon-1-carbonsäureglycidylester und 0,1 g Tetraäthylammoniumbromid in 69 ml Cyclohexan gelöst und 2 Stunden bei 110 °C gerührt. Mit der gekühlten Lösung werden durch Aufschleudern (500 Umdrehungen/Minute) Kupferplatten so beschichtet, dass nach dem Trocknen eine 1–3 μ dicke Polymerschicht auf dem Kupfer gebildet wird. Die beschichteten Platten werden durch eine Negativvorlage (Stufenkeil Stauffer 21-Step-Sensitivity-Guide) mit einer 400 Watt Quecksilberhochdrucklampe in einem Abstand von 60 cm vom Vakuumtisch belichtet. Nach der Belichtung wird das Bild in einem 1,1,1-Trichloräthanbad während 2 Minuten entwickelt, wodurch die unvernetzten Anteile herausgelöst werden. Das resultierende Reliefbild des abgebildeten Stufenkeils wird durch Ätzen der Kupferteile mit einer 50%igen $FeCl_3$-Lösung sichtbar gemacht. Letzte abgebildete Stufe nach:

12 Minuten Stufe 8
6 Minuten Stufe 5
3 Minuten Stufe 4
1 Minute Stufe 2.

Der im obigen Beispiel verwendete Thioxanthon-1-carbonsäureglycidylester kann wie folgt

hergestellt werden: 8,34 g (0,03 Mol) Natriumsalz der Thioxanthon-1-carbonsäure und 0,1 ml Triäthylamin werden in 15 ml Epichlorhydrin solange auf 130 °C erhitzt, bis sich eine dunkle homogene Lösung gebildet hat, und dann während 3 Stunden bei dieser Temperatur gehalten. Anschliessend wird das Reaktionsgemisch mit 50 ml Dioxan verdünnt, zum Rückfluss erhitzt, abgekühlt, und das ausgeschiedene Natriumchlorid wird abgesaugt. Das Lösungsmittel wird eingedampft, und der Rückstand mit 15 ml Diäthyläther verrührt. Das auskristallisierte Rohprodukt wird abgesaugt. Sowohl das auskristallisierte Produkt als auch die Mutterlauge werden über einer Silicagel-Säure gereinigt (Laufmittel Chloroform/Aceton im Volumenverhältnis 19 : 1). Die nach der Chromatographie erhaltenen Produkte werden aus Methanol umkristallisiert. Man erhält 7,54 g Thioxanthon-1-carbonsäureglycidylester; Fp. 115–117 °C. IR-Spektrum (Chloroform): 1750 $cm^{-1}$ (–COOR); 1660 $cm^{-1}$ (–CO–). UV-Spektrum: $\lambda_{max}$ = 385 nm, $\varepsilon$ = 660.

B. Anwendungsbeispiele (Erzeugung von Abbildungen).

Beispiel I

Aus den Polymeren gemäss den Beispielen 1–3 wird je eine auf 13 Gew.-% Feststoffgehalt verdünnte Polymerlösung in 1-Acetoxy-2-äthoxyäthan hergestellt. Mit diesen Polymerlösungen werden durch Aufschleudern (500 Umdrehungen/Minute während 1 Minute) Kupferplatten so beschichtet, dass nach dem Trocknen eine 1–3 µ dicke Polymerschicht auf dem Kupfer gebildet wird. Die beschichteten Platten werden durch eine Negativvorlage (Stufenkeil Stauffer 21-Step-Sensitivity-Guide) mit einer 400 Watt Quecksilberhochdrucklampe in einem Abstand von 50 cm vom Vakuumtisch belichtet. Nach der Belichtung wird das Bild in einem 1,1,1-Trichloräthanband während 2 Minuten entwickelt, wodurch die unvernetzten Anteile herausgelöst werden. Das resultierende Reliefbild des abgebildeten Stufenkeils wird durch Ätzen der blanken Kupferteile mit einer 50%igen $FeCl_3$-Lösung sichtbar gemacht.

Die Resultate sind in der folgenden Tabelle I zusammengefasst.

Beispiel II

Je 1 g der gemäss den Beispielen 7 und 8 hergestellten Polymere wird in 9 ml N,N-Dimethylformamid gelöst. Die erhaltene Lösung wird so auf einen ca. 0,5 mm dicken kupferkaschierten Träger aufgeschleudert, dass nach dem Trocknen ein ca. 3 µ dicker Polymerfilm auf dem Träger erhalten wird. Die so hergestellte Photoplatte wird durch eine Negativvorlage (Stufenkeil Stauffer 21-Step-Sensitivity-Guide) in einem Abstand von 60 cm vom Vakuumtisch unterschiedlich lange mit einer 400 Watt Quecksilberhochdrucklampe bestrahlt. Die belichtete Platte wird in 5%iger $NaHCO_3$-Lösung entwickelt, und die letzte abgebildete Stufe wird durch Anätzen der blanken Kupferteile mit $FeCl_3$ besser sichtbar gemacht.

| Polymer Nr. | letzte abgebildete Stufe nach | | | | | |
|---|---|---|---|---|---|---|
| | Sekunden | | Minuten | | | |
| | 10″ | 30″ | 1′ | 3′ | 6′ | 12′ |
| 7 | 1 | 3 | 5 | 8 | 10 | 12 |
| 8 | | | | 3 | 5 | 7 |

Beispiel III Photographisches Aufzeichnungsmaterial

Auf transparente 100 µm dicke Polyester-Trägerfolien werden mittels eines 25-µm-Handrakels unter Gelblicht lichtempfindliche Polymer-Beschichtungen aus 15%igen Polymerlösungen in Methyläthylketon-Methylcellosolve (Vol.-Verhältnis 1 : 1) aufgetragen. Als Polymere verwendet man die Verbindungen gemäss den Beispielen 4–6. Die Beschichtungen werden bei 100 °C während 3 Minuten getrocknet. Man erhält eine homogene, transparente, schwach gelblich gefärbte Beschichtung, die eine Dicke von 3 µm aufweist. Die derart hergestellten Filme werden auf einem Kopierapparat (Océ Helioprint 36, 1000 W-Metal-Halogenlampe, im Abstand von 53 cm) im Kontakt mit einem Offset-Textkeil durch diesen hindurch während 5–20 Sekunden belichtet. Die belichteten Streifen werden während 15 Sekunden in 2%iges $Na_2CO_3$ getaucht. Dann werden die Streifen 5 Sekunden lang in fliessendem oder deionisiertem Wasser gewaschen und während 30–45 Sekunden in eine 3%ige wässrige Lösung des Farbstoffs der Formel

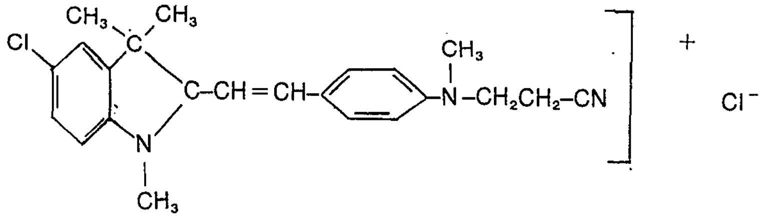

getaucht. Anschliessend werden die Streifen 30 Sekunden lang mit Wasser gespült und getrocknet.

Die Zahl der abgebildeten Stufen des Textkeils sind ein Mass für die Lichtempfindlichkeit der Filme. Die Ergebnisse sind in der folgenden Tabelle II zusammengefasst.

Tabelle I

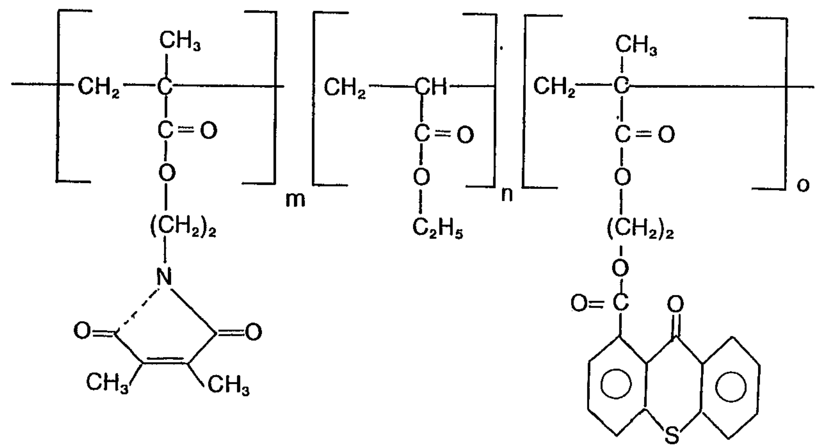

| Polymer Nr. | Mol-gewicht | Polymerzusammensetzung $\frac{m}{n+m+o}$ | $\frac{n}{n+m+o}$ | $\frac{o}{n+m+o}$ | Sensibilisator | Sensibilisator-konzentration Gew. % | Mol | Photoempfindlichkeit letzte abgebildete Stufe nach 20″ | 30″ | 1′ | 3′ | 6′ |
|---|---|---|---|---|---|---|---|---|---|---|---|---|
| 1 | 620 000 | 0,7856 | 0,196 | 0,01836 | 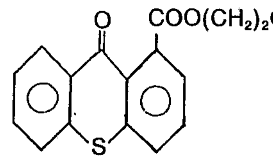 $COO(CH_2)_2OCOC(CH_3)=CH_2$ | 2,7 | $7{,}33 \cdot 10^{-3}$ | 2 | 3 | 5 | 8 | 10 |
| 2 | 780 000 | 0,7927 | 0,198 | 0,0092 | | 1,38 | $3{,}75 \cdot 10^{-3}$ | | | 3 | 6 | 8 |
| 3 | 620 000 | 0,7981 | 0,1988 | 0,0031 | | 0,46 | $1{,}25 \cdot 10^{-3}$ | | | 0 | 2 | 4 |

Tabelle II

| Polymer gemäss Beispiel Nr. | Konzentration des einpolymerisierten Thioxanthons (Gew. %) | Belichtungszeit (Sekunden) | Zahl der abgebildeten Stufen |
|---|---|---|---|
| | | 5 | 4 |
| 4 | 5 | 10 | 6 |
| | | 20 | 7 |
| | | 5 | 5 |
| 5 | 15 | 10 | 7 |
| | | 20 | 8 |
| | | 5 | 6 |
| 6 | 24 | 10 | 7 |
| | | 20 | 9 |

**Patentansprüche**

1. Polymere, deren Durchschnittsmolekulargewicht mindestens 5000 beträgt und die seitenständige Thioxanthongruppierungen der Formel I

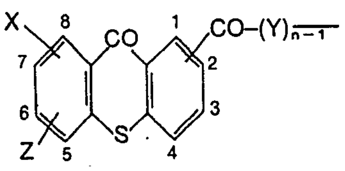

(I)

und seitenständige Imidylgruppierungen der Formel II

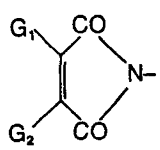

(II)

aufweisen, worin $G_1$ und $G_2$ unabhängig voneinander Alkyl mit 1–4 C-Atomen oder zusammen gegebenenfalls durch Methyl substituiertes Trimethylen oder Tetramethylen,

n die Zahl 1 oder 2,

X Wasserstoff, Halogen, –CN, $-NO_2$, Phenylsulfonyl, Alkylsulfonyl, Alkyl, Alkoxy, Alkylthio, N,N-Dialkylamino oder –CO-Alkyl mit je 1–4 C-Atomen in den Alkylteilen,

Z Wasserstoff, Halogen, Alkyl, Alkoxy, Alkylthio oder N,N-Dialkylamino mit je 1–4 C-Atomen in den Alkylteilen,

Y $-OR_1-$, $-SR_1-$ oder $-N(R_2)R_1-$, wobei das Heteroatom des Restes Y mit der –CO-Gruppe verbunden ist,

$R_1$ gegebenenfalls verzweigtes Alkylen mit insgesamt 2–23 C-Atomen und 2–13 C-Atomen in der Hauptkette, Cyclopentylen, Cyclohexylen, Phenylen oder

$$-(CH_2CH_2O)_x-CH_2CH_2-,$$

$R_2$ Wasserstoff oder gegebenenfalls verzweigtes Alkyl mit insgesamt 1–23 C-Atomen und 1–13 C-Atomen in der Hauptkette und

x eine ganze Zahl von 1–5 bedeuten, wobei der Anteil an Gruppierungen der Formel I 0,1 bis 50 Prozent und der Anteil an Gruppierungen der Formel II 5 bis 99,9 Prozent, bezogen auf die Anzahl der wiederkehrenden Strukturelemente des Polymeren, betragen.

2. Polymere nach Anspruch 1, worin der Anteil an Gruppierungen der Formel I, 0,1 bis 30 Prozent und der Anteil an Gruppierungen der Formel II 10 bis 99,9 Prozent, bezogen auf die Anzahl der wiederkehrenden Strukturelemente des Polymeren, betragen.

3. Polymere nach Anspruch 1, worin der Anteil an Gruppierungen der Formel I 0,1 bis 10 Prozent und der Anteil an Gruppierungen der Formel II 30 bis 99,9 Prozent, bezogen auf die Anzahl der wiederkehrenden Strukturelemente des Polymeren, betragen.

4. Polymere nach Anspruch 1, mit einem Durchschnittsmolekulargewicht von etwa 10 000 bis 1 000 000, die einerseits wiederkehrende Strukturelemente mindestens einer der Formeln IIIa bis XIa

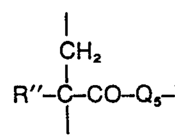

(IIIa),

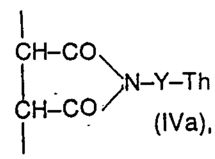

(IVa),

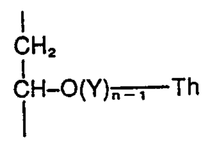

(Va),

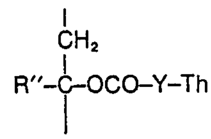

(VIa),

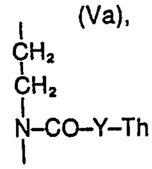

(VIIa),

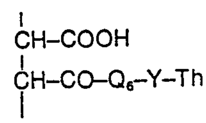

(VIIIa),

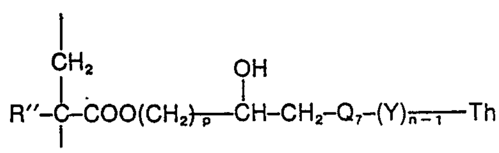

(IXa),

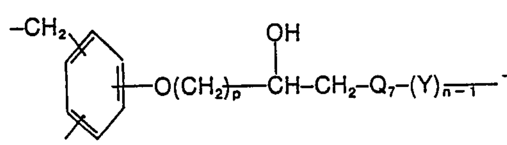

(Xa),

oder

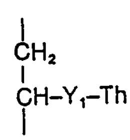

(XIa),

und andererseits wiederkehrende Strukturelemente mindestens einer der Formeln IIIb bis XIIIb

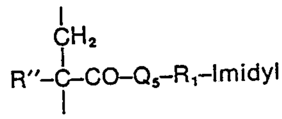
(IIIb),

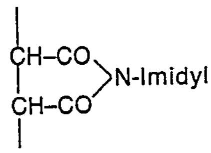
(IVb),

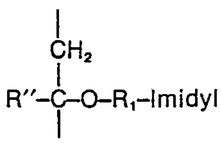
(Vb),

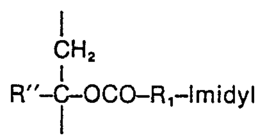
(VIb),

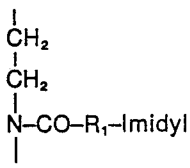
(VIIb),

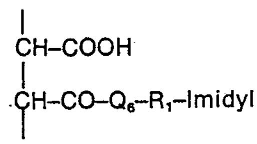
(VIIIb),

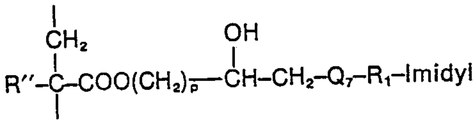
(IXb),

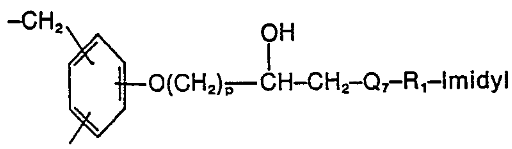
(Xb),

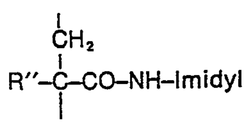
(XIb),

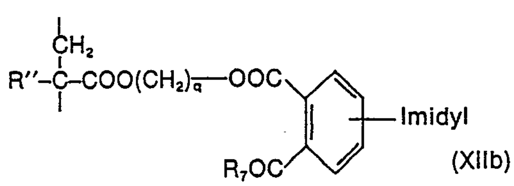
(XIIb) oder

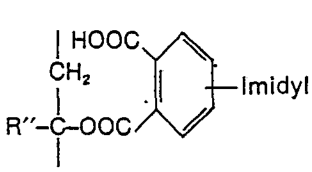
(XIIIb)

aufweisen, worin «Th» einen Rest der Formel I'

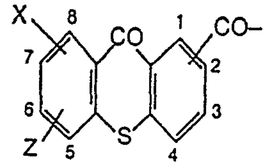
(I')

und «Imidyl» einen Rest der Formel II darstellen, X, Y, Z, $R_1$ und n die unter Formel I angegebene Bedeutung haben,

$Q_5$ –O–, –S– oder –NH–,
$Q_6$ –O–, –S–, –NH– oder –N(R')–,
$Q_7$ –OCO–, –O–, –S–, –NH– oder –N(R')–,
R' Alkyl mit 1–5 C-Atomen,
R'' Wasserstoff oder Methyl,
$R_7$ –OH oder $-O^-M^+$,
$M^+$ ein Alkalimetall-, Pyridinium- oder Trialkylammoniumkation mit 3–24 C-Atomen,
p die Zahl 1 oder 2,
q eine ganze Zahl von 2–4
$Y_1$ $-OR'_1-$, $-SR'_1-$ oder $-NHR'_1$, worin das Heteroatom des Restes $Y_1$ mit der –CO-Gruppe verbunden ist, und $R'_1$ gegebenenfalls verzweigtes Alkylen mit insgesamt 2–23 C-Atomen und 2–13 C-Atomen in der Hauptkette oder Phenylen bedeuten.

5. Polymere nach Anspruch 1 oder 4, worin $G_1$ und $G_2$ je Methyl und Z Wasserstoff bedeuten, n, X und Y die unter Formel I angegebene Bedeutung haben und die Gruppierung $-CO-(Y)_{\overline{n-1}}$ sich in 1- oder 3-Stellung befindet.

6. Polymere nach Anspruch 1 oder 4, worin $G_1$ und $G_2$ je Methyl, X Wasserstoff und Z Wassestoff oder in 7-Stellung gebundenes Methyl oder Methoxy bedeuten, die Gruppe $-CO-(Y)_{\overline{n-1}}$ sich in 1- oder 3-Stellung befindet, Y $-OR_1-$ oder $-NHR_1-$, worin das Heteroatom des Restes Y mit der –CO-Gruppe verbunden ist, und $R_1$ Alkylen mit 2–6 Atomen darstellen.

7. Polymere nach einem der Ansprüche 4–6, die aus wiederkehrenden Strukturelementen mindestens einer der Formeln IIIa bis XIa und mindestens einer der Formeln IIIb bis XIIIb sowie aus wiederkehrenden Strukturelementen der Formel XIV

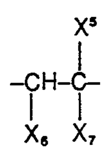
(XIV),

bestehen worin $X_6$ Wasserstoff, $X_5$ Wasserstoff, Chlor oder Methyl, $X_7$ Wasserstoff, Methyl, Chlor, –CN– COOH, $-CONH_2$, Phenyl, Methylphenyl, Methoxyphenyl, Cyclohexyl, Pyridyl, Imidazolyl, Pyrrolidyl, –COO-Alkyl mit 1–12 C-Atomen im Alkylteil, –COO-Phenyl

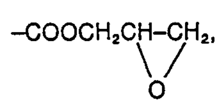

–COO-Alkylen-OH mit 1–3 C-Atomen im Alkylenteil, –OCO-Alkyl mit 1–4 C-Atomen im Alkylteil, –OCO-Phenyl, –CO-Alkyl mit 1–3 C-Atomen im Alkyl, Alkoxy mit 1–20 C-Atomen oder Phenoxy, oder $X_5$ Wasserstoff und $X_6$ und $X_7$ zusammen die Gruppierung

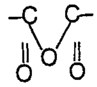

oder je –COOH oder –COO-Alkyl mit 1–6 C-Atomen im Alkyl darstellen.

8. Polymere nach einem der Ansprüche 4–7, die wiederkehrende Strukturelemente mindestens einer der Formeln IIIa, Va, VIa, VIIIa oder XIa und mindestens einer der Formeln IIIb, Vb, VIb oder VIIIb und gegebenenfalls wiederkehrende Strukturelemente der Formel XIV aufweisen, worin R″ Wasserstoff oder Methyl, $Q_5$ –O–, $Q_6$ –O– oder –NH–, n die Zahl 1 oder 2, Y –$OR_1$– oder –$NHR_1$–, worin das Heteroatom des Restes Y mit der –CO-Gruppe verbunden ist, $R_1$ Alkylen mit 2–6 C-Atomen, X Sauerstoff, Z Wasserstoff oder in 7-Stellung gebundenes Methyl oder Methoxy, $X_6$ Wasserstoff, $X_5$ Wasserstoff oder Methyl und $X_7$ –$OCOCH_3$, –COOH oder –COO-Alkyl mit 1–8 C-Atomen im Alkyl, oder $X_5$ und $X_6$ je Wasserstoff und $X_7$ –CN, Chlor, Phenyl oder Alkoxy mit 1–6 C-Atomen im Alkylteil bedeuten und die Carbonylgruppe in Formel I′ in 1- oder 3-Stellung an den Benzolring gebunden ist.

9. Polymeren nach Anspruch 8, die wiederkehrende Strukturelemente mindestens einer der Formeln IIIa oder VIIIa und mindestens einer der Formeln IIIb oder VIIIb, und gegebenenfalls wiederkehrende Strukturelemente der Formel XIV aufweisen, worin R″ Wasserstoff oder Methyl, $Q_5$ –O–, $Q_6$ –O– oder –NH–, n die Zahl 1 oder 2, Y –$OR_1$– oder –$NHR_1$–, $R_1$ Alkylen mit 2–6 C-Atomen, X Wasserstoff, Z Wasserstoff oder in 7-Stellung gebundenes Methyl oder Methoxy, $X_6$ Wasserstoff, $X_5$ Wasserstoff oder Methyl und $X_7$ –$OCOCH_3$, –COOH oder –COO-Alkyl mit 1–8 C-Atomen im Alkyl, oder $X_5$ und $X_6$ je Wasserstoff und $X_7$ –CN, Chlor, Phenyl oder Alkoxy mit 1–6 C-Atomen im Alkylteil bedeuten und die Carbonylgruppe in Formel I′ in 1- oder 3-Stellung an den Benzolring gebunden ist.

10. Polymere nach Ansprüchen 4 und 7, die wiederkehrende Strukturelemente der Formeln IIIa und IIIb sowie wiederkehrende Strukturelemente der Formel XIV aufweisen, worin R″ Methyl, $Q_5$ –O–, Y –O–$CH_2CH_2$–, wobei das Sauerstoffatom des Restes Y mit der –CO-Gruppe verbunden ist, $R_1$ –$CH_2CH_2$–, $X_5$ und $X_6$ je Wasserstoff und $X_7$ –COO–$CH_2CH_3$ bedeuten, der Rest «Th» für die Gruppe

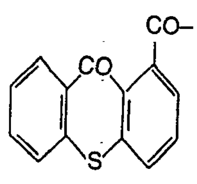

steht und der Rest «Imidyl» die Gruppe

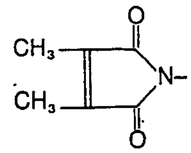

bedeutet.

11. Polymere nach Ansprüchen 4 und 7, die wiederkehrende Strukturelemente der Formeln IIIa und IIIb sowie wiederkehrende Strukturelemente der Formel XIV aufweisen, worin R″ Methyl, $Q_5$ –O–, Y –O–$CH_2CH_2$–, wobei das Sauerstoffatom des Restes Y mit der –CO-Gruppe verbunden ist, $R_1$ –$CH_2CH_2$–, $X_5$ Wasserstoff, $X_6$ Methyl und $X_7$ –COO-n-Butyl oder –COOH bedeuten, der Rest «Th» für die Gruppe

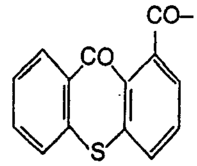

steht und der Rest «Imidyl» die Gruppe

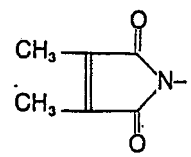

bedeutet.

12. Verfahren zur Herstellung eines Polymeren nach Anspruch 1, dadurch gekennzeichnet, dass man entweder

A) eine Verbindung der Formel Ia

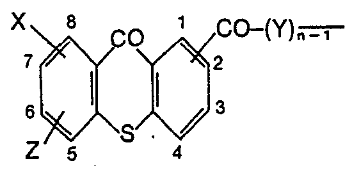

(I)

worin $Q_1$ bei n = 1 –$OCH=CH_2$, –$OCH_2CH=CH_2$, –$SCH_2CH=CH_2$ oder –$NHCH_2CH=CH_2$ und bei n = 2 –OCO–C(R″)$=CH_2$, –SCO–C(R″)$=CH_2$, –NHCO–C(R″)$=CH_2$, –$OCH=CH_2$,

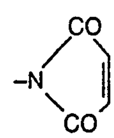

oder, wenn $R_1$ Alkylen oder Phenylen bedeutet, auch –$CH=CH_2$ und R″ Wasserstoff oder Methyl darstellen und für X, Y, Z und n das unter Formel I Angegebene gilt, und eine Verbindung der Formel IIa

$$\text{Imidyl}-(R_1)_{\overline{n-1}}Q_2 \qquad \text{(IIa),}$$

worin «Imidyl» einen Rest der Formel II darstellt, n und $R_1$ die unter Formel I angegebene Bedeutung haben und $Q_2$ bei

n = 1 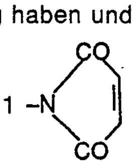 ,

–NHCO-Alkenyl oder

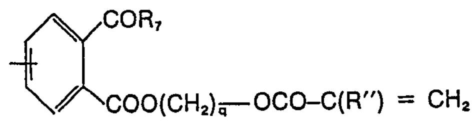

und bei n = 2 –CO–O-Alkenyl, –O-Alkenyl, –OCO-Alkenyl, –NHCO-Alkenyl oder –SCO-Alkenyl bedeutet, wobei die Alkenylteile 2–4 C-Atome aufweisen, $R_7$ –OH oder $-O^-M^+$,

$M^+$ ein Alkalimetall-, Pyridinium- oder Trialkylammoniumkation mit insgesamt 3–24 C-Atomen,

q eine ganze Zahl von 2–4 und

R″ Wasserstoff oder Methyl darstellen; gegebenenfalls in Gegenwart von Comonomeren polymerisiert, wobei das Molverhältnis von Verbindungen der Formel Ia und IIa zu Comonomerem 5,1 : 94,9 bis 100 : 0 und das Molverhältnis von Verbindung der Formel Ia zu Verbindung der Formel IIa 0,1 : 99,9 bis 10 : 1 betragen, oder

B) eine Verbindung der Formel Ib

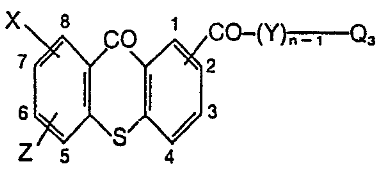 (Ib)

worin X, Y, Z und n die unter Formel I angegebene Bedeutung haben, $Q_3$ bei n = 1

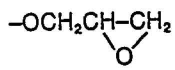

oder $-OCH_2COOH$ und bei n = 2 –OH, –SH, $-NH_2$, –NHR′, $-SO_3H$, –COOH, –COCl, –NCO oder

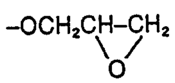

und R′ Alkyl mit 1–5 C-Atomen darstellen, und eine Verbindung der Formel IIb

$$\text{Imidyl}-(R_1)_{\overline{n-1}}Q_4 \quad \text{(IIb)},$$

worin «Imidyl» einen Rest der Formel II darstellt, $R_1$ und n die unter Formel I angegebene Bedeutung haben, $Q_4$ bei n = 1

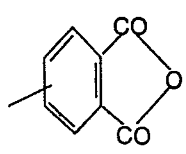

und bei n = 2 –OH, –SH, $-NH_2$, –NHR′, –COOH oder –COCl und R′ Alkyl mit 1–5 C-Atomen bedeuten, mit einem Polymeren mit entsprechenden funktionellen Gruppen in einem Molverhältnis von Verbindungen der Formel Ib + IIb von 5,1 : 100 bis 1 : 1, bezogen auf die Anzahl der wiederkehrenden Strukturelemente des Polymeren, zur Reaktion bringt, wobei das Molverhältnis von Verbindung der Formel Ib zu Verbindung der Formel IIb 0,1 : 99,9 bis 10 : 1 beträgt.

## Claims

A polymer which has a mean molecular weight of not less than 5,000 and contains, in side chains, thioxanthone groupings of the formula I

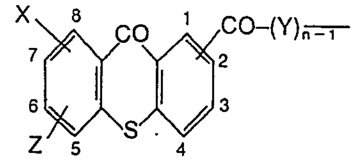 (I)

and, in side chains, imidyl groupings of the formula II

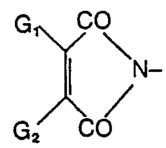 (II)

in which each of $G_1$ and $G_2$ independently of the other is alkyl having 1–4 C atoms or together they are unsubstituted or methyl-substituted trimethylene or tetramethylene, n is 1 or 2, X is hydrogen, halogen, –CN, $-NO_2$, phenylsulfonyl or alkylsulfonyl, alkyl, alkoxy, alkylthio, N,N-dialkylamino or –CO-alkyl each having 1–4 C atoms in the alkyl moiety or moieties, Z is hydrogen, halogen or alkyl, alkoxy, alkylthio or N,N-dialkylamine each having 1–4 C atoms in the alkyl moiety or moieties, Y is $-OR_1-$, $-SR_1-$ or $-N(R_2)R_1-$, and the hetero atom of the radical Y is bonded to the –CO– group, $R_1$ is straight chain or branched alkylene having a total of 2–23 C atoms and 2–13 C atoms in the main chain, or is cyclopentylene, cyclohexylene, phenylene or

$$-(CH_2CH_2O)_x-CH_2CH_2-,$$

$R_2$ is hydrogen or straight chain or branched alkyl having a total of 1–23 C atoms and 1–13 C atoms in the main chain, X is an integer from 1 to 5, the proportion of groupings of the formula I being 0.1 to 50 per cent and the proportion of groupings of the formula II being 5–99,9 per cent, based on the number of recurring structural elements in the polymer.

2. A polymer according to claim 1, in which the proportion of groupings of the formula I is 0.1 to 30 per cent and the proportion of groupings of the formula II is 10 to 99.9 per cent, based on the number of recurring structural elements in the polymer.

3. A polymer according to claim 1, in which the proportion of groupings of the formula I is 0.1 to 10 per cent and the proportion of groupings of the formula II is 30 to 99.9 per cent, based on the number of recurring structural elements in the polymer.

4. A polymer according to claim 1, which has a mean molecular weight of about 10,000 to 1,000,000 and contains, on the one hand, recurring structural elements of at least one of the formulae IIIa to XIa

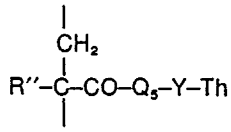
(IIIa)

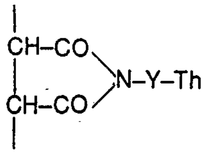
(IVa)

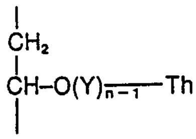
(Va)

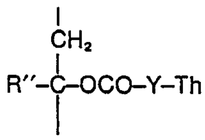
(VIa)

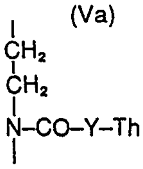
(VIIa)

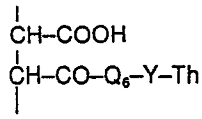
(VIIIa)

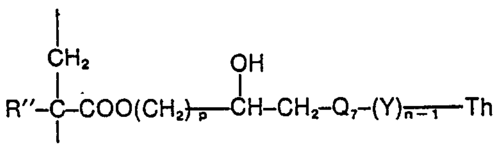
(IXa)

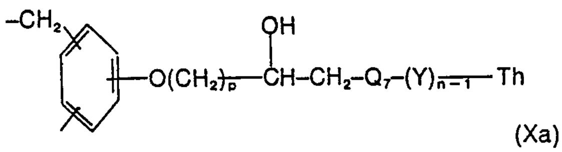
(Xa)

or

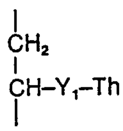
(XIa)

and, on the other hand, recurring structural elements of at least one of the formulae IIIb to XIIIb

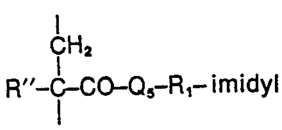
(IIIb)

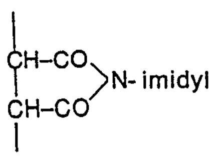
(IVb)

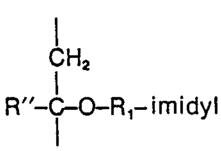
(Vb)

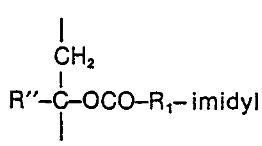
(VIb)

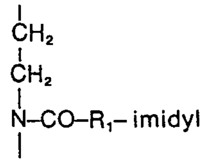
(VIIb)

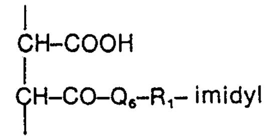
(VIIIb)

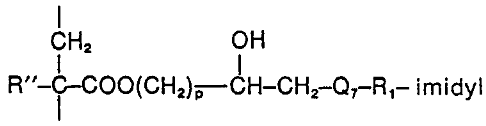
(IXb)

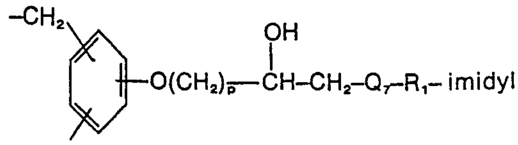
(Xb)

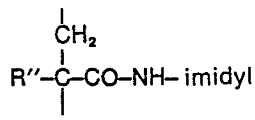
(XIb)

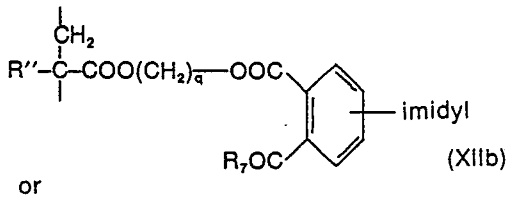
(XIIb)

or

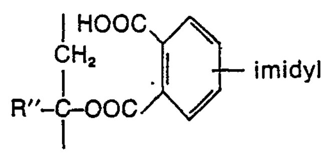
(XIIIb)

in which formulae "Th" is a radical of the formula I′

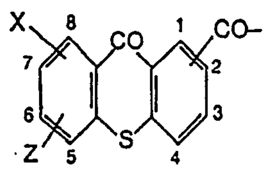
(I′)

and "imidyl" is a radical of the formula II, X, Y, Z, $R_1$ and n are as defined for formula I, $Q_5$ is –O–, –S– or –NH–, $Q_6$ is –O–, –S–, –NH– or –N(R′)–, $Q_7$ is –OCO–, –O–, –S–, –NH– or –N(R′)–, R′ is alkyl having 1–5 C atoms, R″ is hydrogen or methyl, $R_7$ is –OH or $-O^-M^+$, $M^+$ is an alkali metal, a pyridinium or trialkylammonium cation having 3–24 C atoms, p is 1 or 2, q is an integer from 2 to 4, $Y_1$ is $-OR_1'-$, $-SR_1'-$ or $-NHR_1'-$, the hetero atom of the radical $Y_1$ being bonded to the –CO group, and $R_1'$ is straight chain or branched alkylene having a total of 2–23 C atoms and 2–13 C atoms in the main chain, or is phenylene.

5. A polymer according to either of claims 1 or 4, in which each of $G_1$ and $G_2$ is methyl and Z is hydrogen, n, X and Y are as defined for formula I and the grouping $-CO-(Y)_{\overline{n-1}}$ is in the 1-position or 3-position.

6. A polymer according to either of claims 1 or 4, in which each of $G_1$ and $G_2$ is methyl, X is hydrogen and Z is hydrogen or methyl or methoxy bonded in the 7-position, the group $-CO-(Y)_{\overline{n-1}}$ is in the 1-position or 3-position, Y is $-OR_1-$ or $-NHR_1-$, the hetero atom of the radical Y being bonded to the –CO group, and $R_1$ is alkylene having 2–6 C atoms.

7. A polymer according to any one of claims 4 to 6, which consists of recurring structural elements of at least one of the formulae IIIa to XIa and at least one of the formulae IIIb to XIIIb and also of recurring structural elements of the formula XIV

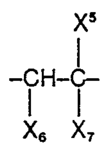
(XIV),

in which $X_6$ is hydrogen, $X_5$ is hydrogen, chlorine or methyl and $X_7$ is hydrogen, methyl, chlorine, –CN, –COOH, $-CONH_2$, phenyl, methylphenyl, methoxyphenyl, cyclohexyl, pyridyl, imidazolyl, pyrrolidyl, –COO-alkyl having 1–12 C atoms in the alkyl moiety, –COO-phenyl,

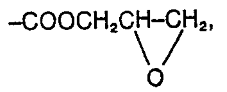

–COO-alkylene-OH having 1–3 C atoms in the alkylene moiety, –OCO-alkyl having 1–4 C atoms in the alkyl moiety, –OCO-phenyl, –CO-alkyl having 1–3 C atoms in the alkyl moiety, alkoxy having 1–20 C atoms or phenoxy, or $X_5$ is hydrogen and $X_6$ and $X_7$ together are the grouping

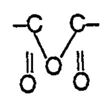

or are each –COOH or –COO-alkyl having 1–6 C atoms in the alkylmoiety.

8. A polymer according to any one of claims 4 to 7, which contains recurring structural elements of at least one of the formulae IIIa, Va, VIa, VIIIa or XIa and at least one of the formulae IIIb, Vb, VIb or VIIIb and, if desired, recurring structural elements of the formula XIV, in which R″ is hydrogen or methyl, $Q_5$ is –O–, $Q_6$ is –O– or –NH–, n is 1 or 2, Y is $-OR_1-$ or $-NHR_1-$, the hetero atom of the radical Y being bonded to the –CO group, $R_1$ is alkylene having 2–6 C atoms, X is oxygen, Z is hydrogen or methyl or methoxy bonded in the 7-position, $X_6$ is hydrogen, $X_5$ is hydrogen or methyl and $X_7$ is $-OCOCH_3$, –COOH or –COO-alkyl having 1–8 C atoms in the alkyl moiety, or each of $X_5$ and $X_6$ is hydrogen and $X_7$ is –CN, chlorine, phenyl or alkoxy having 1–6 C atoms in the alkyl moiety, and the carbonyl group in formula I′ is bonded in the 1-position or 3-position to the benzene ring.

9. A polymer according to claim 8, which contains recurring structural elements of at least one of the formulae IIIa or VIIIa and at least one of the formulae IIIb or VIIIb and, if desired, recurring structural elements of the formula XIV, in which R″ is hydrogen or methyl, $Q_5$ is –O–, $Q_6$ is –O– or –NH–, n is 1 or 2, Y is $-OR_1$ or $-NHR_1-$, $R_1$ is alkylene having 2–6 C atoms, X is hydrogen, Z is hydrogen or methyl or methoxy bonded in the 7-position, $X_6$ is hydrogen, $X_5$ is hydrogen or methyl and $X_7$ is $-OCOCH_3$, –COOH or –COO-alkyl having 1–8 C atoms in the alkyl moiety, or each of $X_5$ and $X_6$ is hydrogen and $X_7$ is –CN, chlorine, phenyl or alkoxy having 1–6 C atoms in the alkyl moiety and the carbonyl group in formula I′ is bonded in the 1-position or 3-position to the benzene ring.

10. A polymer according to either of claims 4 or 7, which contains recurring structural elements of the formulae IIIa and IIIb and also recurring structural elements of the formula XIV, in which R″ is methyl, $Q_5$ is –O–, Y is $-O-CH_2CH_2-$, the oxygen atom of the radical Y being bonded to the –CO group, $R_1$ is $-CH_2CH_2-$, each of $X_5$ and $X_6$ is hydrogen and $X_7$ is $-COO-CH_2CH_3$, the radical "Th" is the group

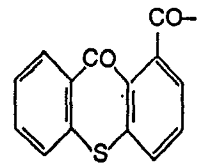

and the radical "imidyl"is the group

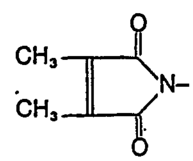

11. A polymer according to either of claims 4 or 7, which contains recurring structural elements of the formulae IIIa and IIIb and also recurring structural elements of the formula XIV, in which R″ is methyl, $Q_5$ is –O–, Y is $-O-CH_2CH_2-$, the oxygen atom of the radical Y being bonded to the –CO group, $R_1$ is $-CH_2CH_2-$, $X_5$ is hydrogen, $X_6$ is methyl and $X_7$ is –COO-n-butyl or –COOH, the radical "Th" is the group

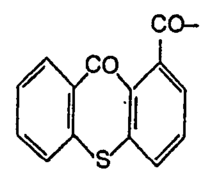

and the radical "imidyl" is the group

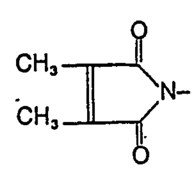

12. A process for the preparation of a polymer according to claim 1, which comprises either

A) polymerising a compound of the formula Ia

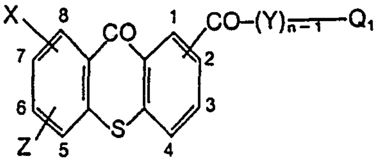

(Ia)

in which $Q_1$ is $-OCH=CH_2$, $-OCH_2CH=CH_2$, $-SCH_2CH=CH_2$ or $-NHCH_2CH=CH_2$ if n is 1, and is $-OCO-C(R'')=CH_2$, $-SCO-C(R'')=CH_2$, $-NHCO-C(R'')=CH_2$, $-OCH=CH_2$ or

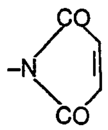

if n is 2, or is also $-CH=CH_2$ if $R_1$ is alkylene or phenylene, and R″ is hydrogen or methyl, and X, Y, Z and n are as defined for formula I, and a compound of the formula IIa

$$\text{imidyl-CR}_1)_{n-1}Q_2 \qquad \text{(IIa)}$$

in which "imidyl" is a radical of the formula II, n and $R_1$ are as defined for formula I and $Q_2$ is

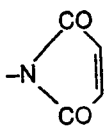

,

-NHCO-alkenyl or

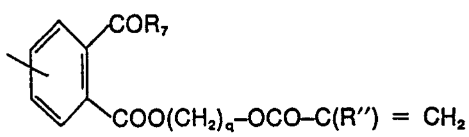

if n is 1, and is -CO-O-alkenyl, -O-alkenyl, -OCO-alkenyl, -NHCO-alkenyl or -SCO-alkenyl, if n is 2, the alkenyl moieties having 2–4 C atoms, and $R_7$ is -OH or $-O^-M^+$, $M^+$ is an alkali metal cation, a pyridinium cation or a trialkylammonium cation having a total of 3–24 C atoms, q is an integer from 2 to 4 and R″ is hydrogen or methyl, of desired, in the presence of comonomers, the molar ratio of compounds of the formulae Ia and IIa to the comonomers being 5.1 : 94.9 to 100 : 0 and the molar ratio of the compound of the formula Ia to the compound of the formula IIa being 0.1 : 99.9 to 10 : 1, or

B) reacting a compound of the formula Ib

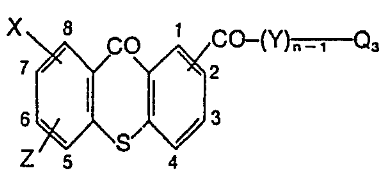

(Ib)

in which X, Y, Z and n are as defined for formula I, $Q_3$ is

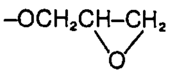

or $-OCH_2-COOH$ if n is 1, and is -OH, -SH, $-NH_2$, -NHR′, $-SO_3H$, -COOH, -COCl, -NCO or

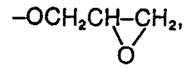

if n is 2, and R′ is alkyl having 1 to 5 C atoms, and a compound of the formula IIb

$$\text{imidyl-}(R_1)_{n-1}Q_4 \qquad \text{(IIb)}$$

in which "imidyl" is a radical of the formula II, $R_1$ and n are as defined for formula I, $Q_4$ is

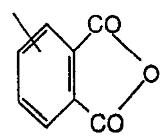

if n is 1, and is -OH, -SH, $-NH_2$, -NHR′, -COOH or -COCl if n is 2, and R′ is alkyl having 1–5 C atoms, with a polymer containing corresponding functional groups, in a molar ratio of compounds of the formula Ib + IIb to the polymer of 5.1 : 100 to 1 : 1, based on the number of recurring structural elements in the polymer, the molar ratio of the compound of the formula Ib to the compound of the formula IIb being 0.1 : 99.9 to 10 : 1.

**Revendications**

1. Polymères dont la masse moléculaire moyenne est d'au moins 5000 et qui contiennent des radicaux thioxanthones latéraux de formule I:

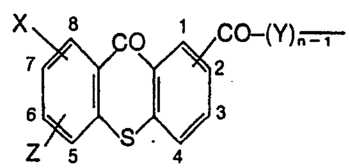

(I)

et des radicaux imidyles latéraux de formula II:

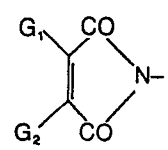

(II) ,

formules dans lesquelles

$G_1$ et $G_2$ représentent chacun, indépendamment l'un de l'autre, un alkyle contenant de 1 à 4 atomes de carbone ou forment ensemble un radical triméthylène ou tétraméthylène éventuellement porteur d'un méthyle,

n représente le nombre 1 ou le nombre 2,

X représente l'hydrogène, un halogène, -CN, $-NO_2$, un phénylsulfonyle, un alkylsulfonyle, un alkyle, un alcoxy, un alkylthio, un N,N-dialkylamino ou un -CO-alkyl contenant de 1 à 4 atomes de carbone dans chacune des parties alkyles,

Z représente l'hydrogène, un halogène, un alkyle, un alcoxy, un alkylthio ou un N,N-dialkylamino contenant de 1 à 4 atomes de carbone dans chacune des parties alkyles,

Y représente $-OR_1-$, $-SR_1$ ou $-N(R_2)R_1-$, l'hétéroatome du racidal R étant relié au radical –CO–,

$R_1$ représente un alkylène éventuellement ramifié qui contient au total de 2 à 33 atomes de carbone et dont la chaîne principale contient de 2 à 13 atomes de carbone, un cyclopentylène, un cyclohexylène, un phénylène ou un radical:

$$-(CH_2CH_2O)_x-CH_2CH_2-,$$

$R_2$ représente l'hydrogène ou un radical alkyle éventuellement ramifié qui contient au total de 1 à 23 atomes de carbone et dont la chaîne principale contient de 1 à 13 atomes de carbone, et

x représente un nombre entier de 1 à 5,

la proportion des radicaux de formule I étant de 0,1 à 50% et celle des radicaux de formule II étant de 5 à 99,9%, par rapport au nombre des motifs répétés du polymère.

2. Polymères selon la revendication 1 dans lesquels la proportion des radicaux de formule I est comprise entre 0,1 et 30% et celle des radicaux de formule II entre 10 et 99,9%, par rapport au nombre des motifs répétés du polymère.

3. Polymères selon la revendication 1 dans lesquels la proportion des radicaux de formule I est comprise entre 0,1 et 10% et celle des radicaux de formule II entre 30 et 99,9%, par rapport au nombre des motifs répétés du polymère.

4. Polymères selon la revendication 1 qui ont une masse moléculaire moyenne d'environ 10 000 á 1 000 000 et qui contiennent, d'une part, des motifs répétés répondant à au moins une des formules IIIa à XIa:

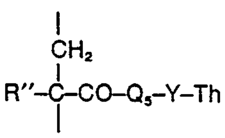
(IIIa),

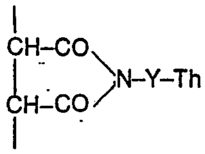
(IVa),

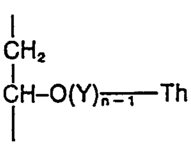
(Va),

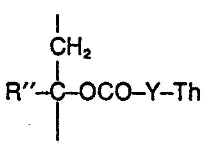
(VIa),

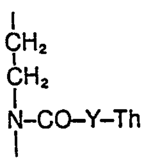
(VIIa),

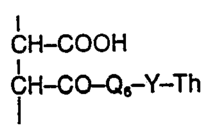
(VIIIa),

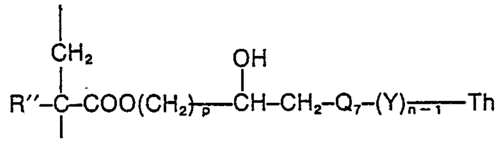
(IXa),

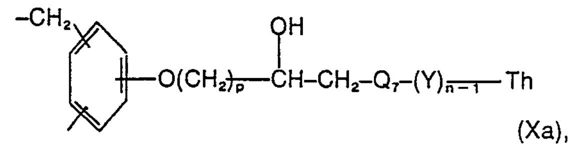
(Xa),

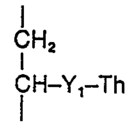
(XIa),

et, d'autre part, des motifs répétés répondant à au moins une des formules IIIb à XIIIb:

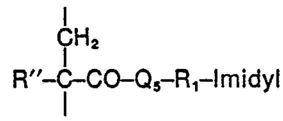
(IIIb),

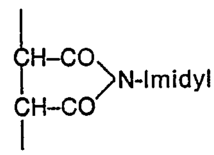
(IVb),

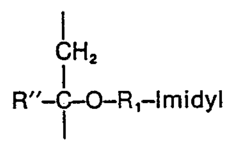
(Vb),

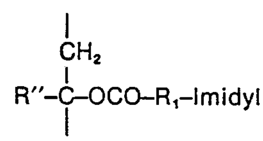
(VIb),

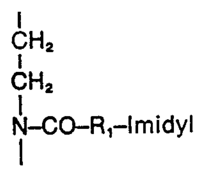
(VIIb),

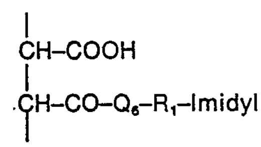
(VIIIb),

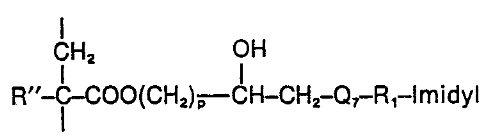
(IXb),

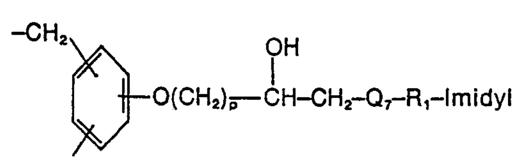
(Xb),

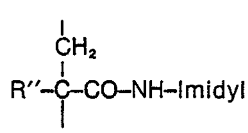
(XIb),

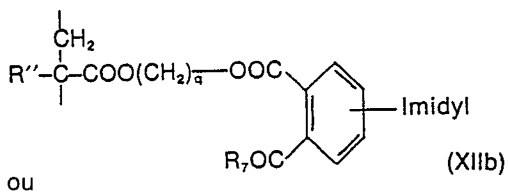

(XIIb)

ou

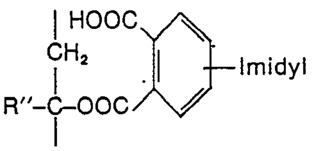

(XIIIb),

formules dans lesquelles:

«Th» représente un radical de formule I':

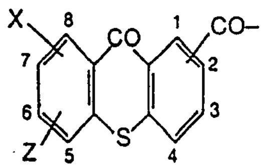

(I'),

«Imidyl» représente un radical de formule II,

X, Y, Z, $R_1$ et n ont les significations données au-dessous de la formule I,

$Q_5$ représente –O–, –S– ou –NH–,

$Q_6$ représente –O–, –S–, –NH– ou –N(R')–,

$Q_7$ représente –OCO–, –O–, –S–, –NH– ou –N(R')N–,

R' représente un alkyle contenant de 1 à 5 atomes de carbone,

R'' représente l'hydrogène ou un méthyle,

$R_7$ représente –OH ou $-O^-M^+$,

$M^+$ représente un ion de métal alcalin, de pyridinium ou de trialkylammonium contenant de 3 à 24 atomes de carbone,

p représente le nombre 1 ou le nombre 2,

q représente un nombre entier de 2 à 4,

$Y_1$ représente $-OR_1'-$, $-SR_1'-$ ou $-NHR_1'-$, l'hétéroatome du racidal $Y_1$ étant relié au radical –CO–, et $R_1'$ représentant un alkylène éventuellement ramifié qui contient au total de 2 à 23 atomes de carbone dont de 2 à 13 dans sa chaîne principale, ou un radical phénylène.

5. Polymères selon l'une des revendications 1 et 4, dans lesquels $G_1$ et $G_2$ représentent chacun un méthyle, Z représente l'hydrogène, n, X et Y ont les significations données au-dessous de la formule I et le radical $-CO-(Y)_{\overline{n-1}}$ se trouve en position 1 ou en position 3.

6. Polymères selon l'une des revendications 1 et 4, dans lesquels $G_1$ et $G_2$ représentent chacun un méthyle, X représente l'hydrogène, Z représente l'hydrogène ou un radical méthyle ou méthoxy en position 7, le radical $-CO-(Y)_{\overline{n-1}}$ se trouve en position 1 ou en position 3, Y représente un radical $-OR_1-$ ou $-NHR_1-$ dont l'hétéroatome est relié au radical –CO–, et $R_1$ représente un alkylène contenant de 2 à 6 atomes de carbone.

7. Polymères selon l'une quelconque des revendications 4 à 6, qui sont constitués de motifs répétés répondant à au moins une des formules IIIa à XIa et à au moins une des formules IIIb à XIIIb, ainsi que de motifs répétés répondant à la formule XIV:

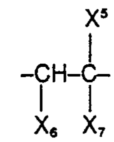

(XIV)

dans laquelle $X_6$ représente l'hydrogène, $X_5$ représente l'hydrogène, le chlor ou un méthyle et $X_7$ représente l'hydrogène, un méthyle, le chlore, –CN–, –COOH–, $-CONH_2$, un phényle, un méthylphényle, un méthoxyphényle, un cyclohexyle, un pyridyle, un imidazolyle, un pyrrolidyle, un radical –COO-alkyl contenant de 1 à 12 atomes de carbone dans sa partie alkyle, un radical –COO-phényl,

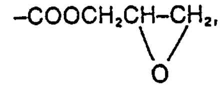

un radical –COO-alkylène-OH contenant de 1 à 3 atomes de carbone dans sa partie alkyle, un radical –OCO-Alkyl contenant de 1 à 4 atomes de carbone dans sa partie alkyle, un radical –OCO-phényle, un radical –CO-alkyle contenant de 1 à 3 atomes de carbone dans sa partie alkyle, un alcoxy contenant de 1 à 20 atomes de carbone ou un phénoxy, ou $X_5$ représente l'hydrogène tandis que $X_6$ et $X_7$ forment ensemble un groupement

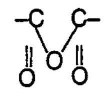

ou représentent chacun un radical –COOH ou un radical –COO-alkyl contenant de 1 à 6 atomes de carbone dans sa partie alkyle.

8. Polymères selon l'une quelconque des revendications 4 à 7 qui contiennent des motifs répétés qui répondent à au moins une des formules IIIa, Va, VIa, VIIIa et XIa et à au moins une des formules IIIb, Vb, VIb et VIIIb et éventuellement des motifs répétés de formule XIV, formules dans lesquelles R'' représente l'hydrogène ou un méthyle, $Q_5$ représente –O–, $Q_6$ représente –O– ou –NH–, n représente le nombre 1 ou le nombre 2, Y représente un radical $-OR_1-$ ou $-NHR_1$ dont l'hétéroatome est relié au radical –CO–, $R_1$ représente un alkylène contenant de 2 à 6 atomes de carbone, X représente l'oxygène, Z représente l'hydrogène ou un radical méthyle ou méthoxy en position 7, $X_6$ représente l'hydrogène, $X_5$ représente l'hydrogène ou un méthyle et $X_7$ représente $-OCOCH_3$, –COOH ou un radical –COO-alkyl contenant de 1 à 8 atomes de carbone dans sa partie alkyle, ou encore $X_5$ et $X_6$ représentent chacun l'hydrogène et $X_7$ représente –CN, le chlore, un phényle ou un alcoxy contenant de 1 à 6 atomes de carbone dans sa partie alkyle, et le radical carbonyle, dans la formule I', est lié à la position 1 ou à la position 3 du noyau benzénique.

9. Polymères selon la revendication 8 qui contiennent des motifs répétés répondant à au moins une des formules IIIa et VIIIa et à au moins une des formules IIIb et VIIIb, et qui contiennent éventuellement des motifs répétés de formule XIV, formules dans lesquelles R'' représente l'hydrogène ou

un méthyle, $Q_5$ représente –O–, $Q_6$ représente –O– ou –NH–, n représente le nombre 1 ou le nombre 2, Y représente $-OR_1$ ou $-NHR_1$, $R_1$ représente un alkylène contenant de 2 à 6 atomes de carbone, X représente l'hydrogène, Z représente l'hydrogène ou un radical méthyle ou méthoxy occupant la position 7, $X_6$ représente l'hydrogène, $X_5$ représente l'hydrogène ou un méthyle et $X_7$ représente $-OCOCH_3$, –COOH ou un radical –COO-alkyl contenant de 1 â 8 atomes de carbone dans sa partie alkyle, ou encore $X_5$ et $X_6$ représentent chacun l'hydrogène et $X_7$ représente –CN, le chlore, un phényle ou un alcoxy contenant de 1 à 6 atomes de carbone dans sa partie alkyle, et le radical carbonyle, dans la formule I', se trouve en position 1 ou en position 3 sur le noyau benzénique.

10. Polymères selon l'une des revendications 4 et 7, qui contiennent des motifs répétés de formules IIIa et IIIb ainsi que des motifs répétés de formule XIV, formules dans lesquelles R'' représente un méthyle, $Q_5$ représente –O–, Y représente un radical $-O-CH_2CH_2-$ relié par son atome d'oxygène au radical –CO–, $R_1$ représente $-CH_2CH_2-$, $X_5$ et $X_6$ représentent chacun l'hydrogène, $X_7$ représente $-COO-CH_2CH_3$, «Th» représente le radical:

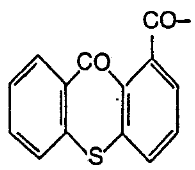

et «Imidyl» représente le radical:

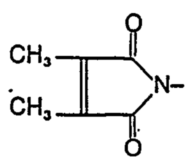

11. Polymères selon l'une des revendications 4 et 7, qui contiennent des motifs répétés de formules IIIa et IIIb ainsi que des motifs répétés de formule XIV, formules dans lesquelles R'' représente un méthyle, $Q_5$ représente –O–, Y représente un radical $-O-CH_2CH_2-$ relié par son atome d'oxygène au radical –CO–, $R_1$ représente $-CH_2CH_2-$, $X_5$ représente l'hydrogène, $X_6$ représente un méthyle, $X_7$ représente un radical –COO-n-butyl ou –COOH, Th représente le radical:

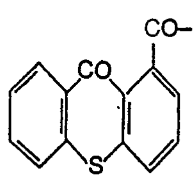

et «Imidyl» représente le radical:

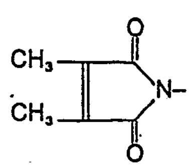

12. Procédé de préparation d'un polymère selon la revendication 1, procédé caractérisé en ce que: ou bien A) on polymérise, éventuellement en présence de comonomères, un composé répondant à la formule Ia:

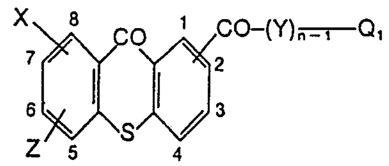

(Ia)

dans laquelle $Q_1$, dans le cas où n est égal à 1, représente un radical $-OCH=CH_2$, $-OCH_2CH=CH_2$, $-SCH_2CH=CH_2$ ou $-NHCH_2CH=CH_2$, et, dans le cas où n est égal à 2, un radical $-OCO-C(R'')=CH_2$, $-SCO-C(R'')=CH_2$, $-NHCO-C(R'')=CH_2$, $-OCH=CH_2$, ou

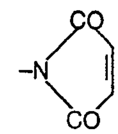

ou encore, lorsque $R_1$ désigne un alkylène ou un phénylène, $Q_1$ peut également représenter un radical $-CH=CH_2$, R'' représente l'hydrogène ou un méthyle et les symboles X, Y, Z et n ont les significations données au-dessous de la formule I, et un composé répondant à la formule IIa:

$$\text{Imidyl}-(R_1)_{\overline{n-1}}Q_2 \qquad \text{(IIa)}$$

dans laquelle «Imidyl» représente un radical de formule II, n et $R_1$ ont les significations données au-dessous de la formule I, et $Q_2$ représente, dans le cas où n est égal à 1, un radical

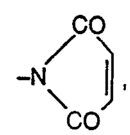

–NHCO-alcényl ou

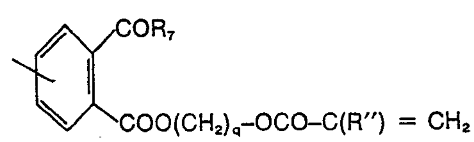

et, dans le cas où n est égal à 2, un radical alcényloxycarbonyle, alcényloxy, alcénylcarbonyloxy, alcénylcarbonylamino ou alcénylcarbonylthio, les parties alcényliques de ces radicaux contenant chacune de 2 à 4 atomes de carbone, $R_7$ représente un radical –OH ou $-O^-M^+$, $M^+$ désigne un cation d'un métal alcalin, un cation pyridinium ou un cation trialkylammonium contenant au total de 3 à 24 atomes de carbone, q désigne un nombre entier de 2 à 4, et R'' représente l'hydrogène ou un méthyle, le rapport molaire des composés (Ia) + (IIa) aux comonomères étant compris entre 5,1 : 94,9 et 100 : 0 et le rapport molaire du composé (Ia) au composé (IIa) étant compris entre 0,1 : 99,9 et 10 : 1, ou bien B)

on fait réagir un composé répondant à la formule Ib:

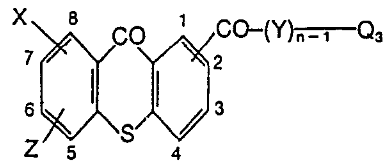

(Ib)

dans laquelle X, Y, Z et n ont les significations données au-dessous de la formule I, $Q_3$ représente, dans le cas où n est égal à 1, un radical

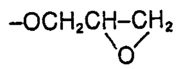

ou $-OCH_2-COOH$ et, dans le cas où n est égal à 2, un radical $-OH$, $-SH$, $-NH_2$, $-NHR'$, $-SO_3H$, $-COOH$, $-COCl$, $-NCO$ ou

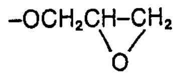

et R′ représente un alkyle contenant de 1 à 5 atomes de carbone, et un composé répondant à la formule IIb:

$$Imidyl{-}(R_1)_{\overline{n-1}}Q_4 \qquad (IIb)$$

dans laquelle Imidyl représente un radical de formule II, $R_1$ et n ont les significations données au-dessous de la formule I, $Q_4$ représente, dans le cas où n est égal à 1, un radical

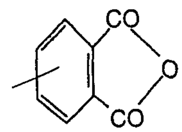

et, dans le cas où n est égal à 2, un radical $-OH$, $-SH$, $-NH_2$, $-NHR'$, $-COOH$ ou $-COCl$, et R′ représente un alkyle contenant de 1 à 5 atomes de carbone, avec un polymère porteur de radicaux fonctionnels, dans un rapport molaire des composés (Ib) + (IIb) compris entre 5,1 : 100 et 1 : 1 par rapport au nombre des motifs répétés du polymère, le rapport molaire du composé de formule Ib au composé de formule IIb étant compris entre 0,1 : 99,9 et 10 : 1.